# EUROPÄISCHE PATENTSCHRIFT

(11) **EP 4 169 361 B1**
(45) Veröffentlichungstag und Bekanntmachung des Hinweises auf die Patenterteilung: **11.12.2024**
(21) Anmeldenummer: 21754989.8
(22) Anmeldetag: 04.08.2021
(51) Int. Cl.: H05K 7/14, H05K 7/20

(54) **SCHALTSCHRANKSYSTEM MIT EINEM BASISMODUL UND EINEM FUNKTIONSMODUL, BASISMODUL UND FUNKTIONSMODUL**
CONTROL CABINET SYSTEM COMPRISING A BASE MODULE AND A FUNCTIONAL MODULE, BASE MODULE AND FUNCTIONAL MODULE
SYSTÈME DE COFFRET DE COMMANDE COMPRENANT UN MODULE DE BASE ET UN MODULE FONCTIONNEL, MODULE DE BASE ET MODULE FONCTIONNEL

(30) Priorität: 07.08.2020 DE 102020120918
(43) Veröffentlichungstag der Anmeldung: 26.04.2023
(73) Patentinhaber: Beckhoff Automation GmbH, 33415 Verl (DE)
(72) Erfinder: BECKHOFF, Hans, 33415 Verl (DE); WITTENBORG, Peter, 33415 Verl (DE); SIEGENBRINK, Daniel, 33617 Bielefeld (DE)
(74) Vertreter: Patentanwaltskanzlei WILHELM & BECK
(86) Internationale Anmeldenummer: PCT/EP2021/071772
(87) Internationale Veröffentlichungsnummer: WO 2022/029177

(56) Entgegenhaltungen:
- DE-A1- 102014 104 857
- DE-A1- 102018 133 646
- DE-A1- 102018 133 657
- DE-A1- 102019 106 082

## Beschreibung

Die Erfindung betrifft ein Schaltschranksystem mit einem Basismodul und einem Funktionsmodul. Darüber hinaus betrifft die Erfindung ein Basismodul und ein Funktionsmodul für ein Schaltschranksystem.

In modular aufgebauten Feldbussystemen, die beispielsweise in Automatisierungssystemen zum Einsatz kommen können, können Funktionsmodule direkt miteinander verbunden werden oder jeweils mit einem Basismodul verbunden werden. In der letzteren Variante können Datenanschlüsse und Kleinspannungsanschlüsse am Basismodul bereitgestellt sein, mit denen die Funktionsmodule verbunden werden. Dadurch ist ein einfacher Aufbau des modularen Feldbussystems möglich. Die Funktionsmodule können dabei verschiedene Funktionalitäten übernehmen und beispielsweise als Eingangsmodule, Ausgangsmodule, SPS-Steuerungsmodule, Motorsteuerungsmodule oder Netzteilmodule ausgestaltet sein. Über einen Feldbus, beziehungsweise über eine Schnittstelle, deren Bestandteile neben dem Feldbus zur Datenkommunikation, eine Spannungsversorgung einer Kleinspannung ist, wird sowohl eine Kommunikationsmöglichkeit als auch eine Spannungsversorgung mit einer Kleinspannung bereitgestellt.

Nachteilig an diesem Feldbussystem ist also, dass für Funktionsmodule wie beispielsweise eine Motorsteuerung, für die eine höhere Spannung notwendig ist, ein eigener Netzanschluss bereitgestellt werden muss. Dadurch ist die Verkabelung und Installation eines solchen Feldbussystems kompliziert, wenn durch das Feldbussystem die Funktionalität eines Schaltschranks bereitgestellt werden soll. Ein Schaltschrank kann dabei die elektrischen und elektronischen Komponenten einer verfahrenstechnischen Anlage, einer Werkzeugmaschine oder Fertigungseinrichtung beinhalten, die sich nicht direkt in der Maschine befinden.

Für Schaltschranksysteme, insbesondere modulare Schaltschranksysteme mit einem Basismodul und mehreren mit dem Basismodul verbindbaren Funktionsmodulen, stellt sich das Problem der übermäßigen Wärmeentwicklung der einzelnen elektrischen wie auch elektronischen Komponenten des Basismoduls beziehungsweise der Funktionsmodule. Für Schaltschranksysteme, die aufgrund des vorgesehenen Einsatzbereichs beispielsweise die Schutzart IP67 erfüllen müssen und die Schaltschranksysteme somit staubdicht und vollständig gegen Berührung geschützt sein müssen, besteht das Problem der Kühlung beziehungsweise des Abtransports der entstandenen Wärme der elektrischen beziehungsweise elektronischen Komponenten. Aufgrund der gegebenenfalls luftdichten beziehungsweise fluiddichten Ausgestaltung der Gehäuse der einzelnen Module des Schaltschranksystems ist ein Einsatz einer externen aktiven Kühlung, bei der eine entstandene Wärme durch die aktive Einführung externer Kühlmittel abgeführt wird, technisch aufwendig, kostspielig und mit dem Einsatz zusätzlicher Bauteile verbunden, die einen Platzbedarf des Schaltschranksystems erhöhen. Für viele Einsatzbereiche sind derartige aktive externe Kühllösungen daher unattraktiv.

Das Dokument DE 10 2018 133646 A1 offenbart ein Schaltschranksystem mit einem Basismodul und wenigstens einem Funktionsmodul, wobei das Basismodul Spannungs- und Datenanschlüsse für das Funktionsmodul aufweist sowie einen Kühlluftkanal, an den das Funktionsmodul angeschlossen werden kann. Ein weiteres Schaltschranksystem mit einem Basismodul und Funktionsmodulen wird in der DE 10 2018 133657 A1 gezeigt. Die DE 10 2014 104857 A1 zeigt ein Schaltschranksystem mit einem durch auf einer Hutschiene montierten Baugruppen gebildeten Luftkanal.

Eine Aufgabe der vorliegenden Erfindung ist es, ein Schaltschranksystem mit einem Basismodul und wenigstens einem Funktionsmodul bereitzustellen, das über einen verbesserten Kühlmechanismus verfügt. Ferner ist eine Aufgabe der Erfindung, ein Basismodul und ein Funktionsmodul für ein Schaltschranksystem mit verbessertem Kühlmechanismus bereitzustellen.

Diese Aufgaben werden durch das Schaltschranksystem und das Funktionsmodul der unabhängigen Patentansprüche gelöst. Weiterbildungen sind in den abhängigen Ansprüchen angegeben.

Nach einem Aspekt der Erfindung wird ein Schaltschranksystem mit einem Basismodul und wenigstens einem Funktionsmodul bereitgestellt, wobei das Basismodul ein Basisgehäuse mit einer ersten Gehäuseseite und einer zweiten Gehäuseseite aufweist, wobei an der ersten Gehäuseseite eine Mehrzahl von Basisanschlusselementen mit Basisspannungsanschlüssen und Basisdatenanschlüssen angeordnet ist, wobei im Basisgehäuse wenigstens eine Datenleitung mit einer Mehrzahl von Anschalteinheiten, die über die Datenleitung mit den Basisdatenanschlüssen der Basisanschlusselemente verbunden ist, und wenigstens eine Spannungsleitung angeordnet sind, die mit den Basisspannungsanschlüssen der Basisanschlusselemente verbunden ist, wobei das Funktionsmodul ein Funktionsgehäuse mit einer Gehäuseunterseite aufweist, wobei an der Gehäuseunterseite ein Funktionsanschlusselement mit Spannungsanschlüssen und Datenanschlüssen angeordnet ist, wobei im Funktionsgehäuse wenigstens eine elektronische Funktionsschaltung angeordnet ist, die mit den Spannungsanschlüssen und den Datenanschlüssen des Funktionsanschlusselements verbunden ist, wobei über eine Kopplung des Funktionsanschlusselements mit einem der Basisanschlusselemente das Funktionsmodul mit dem Basismodul verbindbar und eine Verbindung der Spannungsanschlüsse und Datenanschlüsse des Funktionsanschlusselements mit den Basisspannungsanschlüssen und Basisdatenanschlüssen des Basiselements erzielbar ist, wobei im Basisgehäuse ein Zirkulationskanal angeordnet ist, wobei im Zirkulationskanal ein Luftstrom zirkulierbar ist, wobei jedes Basisanschlusselement Zirkulationsöffnungen aufweist, die mit dem Zirkulationskanal fluidtechnisch verbunden sind, wobei das Funktionsanschlusselement Kopplungsöffnungen aufweist, die mit einem Inneren des Funktionsgehäuses fluidtechnisch verbunden sind, wobei die Kopplungsöffnungen mit den Zirkulationsöffnungen koppelbar sind, und wobei in einer Kopplung der Kopplungsöffnungen mit den Zirkulationsöffnungen eine fluidtechnische Verbindung zwischen dem Zirkulationskanal und dem Inneren des Funktionsgehäuses besteht und ein fluidtechnisch geschlossener Zirkulationskreislauf umfassend den Zirkulationskanal und das Innere des Funktionsgehäuses gebildet ist, in dem ein Luftstrom zirkulierbar ist.

Hierdurch wird der technische Vorteil erreicht, dass ein Schaltschranksystem bereitgestellt werden kann, bei dem mittels einer passiven Kühlung elektrische wie auch elektronische Komponenten beziehungsweise Bauteile des Schaltschranksystems gekühlt werden können. Hierzu stellt ein Basismodul des Schaltschranksystems einen Zirkulationskanal bereit, in dem ein Luftvolumen zirkulierbar ist. Das Basismodul weist ferner eine Mehrzahl von Zirkulationsöffnungen auf, die in fluidtechnischer Verbindung zum Zirkulationskanal stehen und in eine Mehrzahl von Basisanschlusselementen integriert sind, die zum Ankoppeln von Funktionsmodulen des Schaltschranksystems an das Basismodul dienen. Die Funktionsmodule des Schaltschranksystems weisen entsprechende Kopplungsöffnungen auf, die in fluidtechnischer Verbindung zu einem Inneren eines Funktionsgehäuses der jeweiligen Funktionsmodule stehen und in die jeweiligen Funktionsanschlusselemente der Funktionsmodule integriert sind.

Über eine Kopplung eines Funktionsanschlusselements eines Funktionsmoduls an ein entsprechendes Basisanschlusselement des Basismoduls, wodurch eine Verbindung des Funktionsmoduls mit dem Basismodul erreicht wird, kann über eine Kopplung der Kopplungsöffnungen des Funktionsanschlusselements des Funktionsmoduls mit den Zirkulationsöffnungen des entsprechenden Basisanschlusselements des Basismoduls eine fluidtechnische Verbindung zwischen dem Inneren des Funktionsgehäuses des Funktionsmoduls und dem Zirkulationskanal des Basismoduls erreicht werden. Über die fluidtechnische Verbindung zwischen dem Inneren des Funktionsgehäuses des Funktionsmoduls und dem Zirkulationskanal des Basismoduls kann somit ein Austausch von Luft innerhalb des Funktionsgehäuses des Funktionsmoduls und dem Luftvolumen innerhalb des Zirkulationskanals des Basismoduls erreicht werden. Durch die fluidtechnische Verbindung zwischen dem Inneren des Funktionsgehäuses des Funktionsmoduls und dem Zirkulationskanal des Basismoduls kann somit ein in sich geschlossener Zirkulationskreislauf hergestellt werden, der durch das Innere des Funktionsgehäuses des Funktionsmoduls und den Zirkulationskanal gebildet ist, und in dem eine Zirkulation des darin enthaltenen Luftvolumens beziehungsweise ein zirkulierender Luftstrom generiert werden kann.

Durch die Zirkulation des Luftvolumens innerhalb beziehungsweise entlang des Zirkulationskreislaufs kann somit eine durch den Betrieb einer innerhalb des Funktionsgehäuses des Funktionsmoduls angeordneten elektronischen Funktionsschaltung entstandene Wärme abtransportiert und somit ein Kühleffekt der Funktionsschaltung erreicht werden. Insbesondere kann durch die Zirkulation des Luftvolumens im Inneren des Funktionsgehäuses eine Bildung von Wärmestaunestern innerhalb des Funktionsgehäuses vermieden werden.

Wärmestaunester beschreiben hierbei die Erwärmung eines eine Komponente beziehungsweise Komponenten der elektronischen Funktionsschaltung umgebenden Luftvolumens, die aufgrund einer mangelhaften Vermischung des erwärmten Luftvolumens mit weiterem Luftvolumen innerhalb des Funktionsgehäuses zu einer substantiellen und stark lokalisierten Temperaturerhöhung des das jeweilige Bauteil oder die Komponente umgebenden Luftvolumens. Hierdurch kann eine übermäßige Erwärmung der jeweiligen Komponenten der Funktionsschaltung und damit verbunden eine Schädigung der Komponenten erfolgen. Durch die Luftzirkulation innerhalb des Funktionsgehäuses können diese Wärmestaunester verwirbelt und somit eine übermäßige Erwärmung des die Funktionsschaltung umgebenden Luftvolumens vermieden werden. Somit kann eine passive Kühlung der Funktionsschaltung beziehungsweise der Komponenten und Bauteile der Funktionsschaltung erreicht werden.

Darüber hinaus stellt der Zirkulationskreislauf einen in sich geschlossenen Kreislauf dar, bei dem ein Austausch von Luftvolumen innerhalb des Zirkulationskreislaufs mit einer das Schaltschranksystem umgebenden Umgebungsluft vermieden ist. Somit kann eine passive Kühlung der Komponenten und Bauteile des Funktionsmoduls des Schaltschranksystems erreicht und eine Staubdichtigkeit beziehungsweise eine Fluiddichtigkeit des Schaltschranksystems gewährleistet werden.

Durch die Integration der fluidtechnisch mit dem Zirkulationskanal verbundenen Zirkulationsöffnungen in die Basisanschlusselemente des Basismoduls beziehungsweise durch die Integration der fluidtechnisch mit dem Inneren des Funktionsgehäuses des Funktionsmoduls verbundenen Kopplungsöffnungen in die Funktionsanschlusselemente des Funktionsmoduls kann erreicht werden, dass durch einen Anschluss eines Funktionsmoduls an das Basismodul durch die Kopplung der Funktionsanschlusselemente des Funktionsmoduls an entsprechende Basisanschlusselemente des Basismoduls automatisch eine Kopplung des Funktionsmoduls an den Zirkulationskreislauf des Schaltschranksystems erreicht ist. Ein an das Basismodul des Schaltschranksystems angeschlossenes Funktionsmodul ist somit automatisch in den Zirkulationskreislauf integriert und nimmt an der passiven Kühlung durch die Luftzirkulation innerhalb des Zirkulationskreislaufs, der für eine Luftzirkulation im Inneren des Funktionsgehäuses des jeweiligen Funktionsmoduls sorgt, teil. Ein zusätzlicher Anschluss des jeweiligen Funktionsmoduls an ein zusätzliches Kühlungssystem ist somit nicht nötig.

Darüber hinaus können über die Mehrzahl von Basisanschlusselementen und die darin integrierten Zirkulationsöffnungen eine Mehrzahl von Funktionsmodulen in den Zirkulationskreislauf integriert werden und somit an der Luftzirkulation innerhalb des Zirkulationskreislaufs und der damit verbundenen Kühlung teilhaben.

Über die Funktionsschaltungen innerhalb der Funktionsmodule beziehungsweise der entsprechenden Basisspannungsanschlüsse beziehungsweise Basisdatenanschlüsse innerhalb des Basismoduls kann eine übliche Funktionalität eines Schaltschranksystems bereitgestellt werden.

Die Spannungsleitung kann eine Kleinspannungsleitung und eine Niederspannungsleitung umfassen. Die Spannungsanschlüsse können entsprechend Kleinspannungsanschlüsse und Niederspannungsanschlüsse umfassen.

Kleinspannungen sollen dabei elektrische Spannungen bis zu 50 Volt Wechselspannung und/oder 120 Volt Gleichspannung, insbesondere bis zu 25 Volt Wechselspannung und/oder 60 Volt Gleichspannung, sein. Diese Definition einer Kleinspannung kann der Norm IEC60449 entnommen werden. Niederspannungen sollen dabei elektrische Spannungen oberhalb der Kleinspannung und bis zu 1000 Volt Wechselspannung und/oder 1500 Volt Gleichspannung sein. Ferner kann vorgesehen sein, eine Versorgungsspannung für Kommunikationselektronik mittels der Datenleitung bereitzustellen. Diese Versorgungsspannung kann im Bereich einiger Volt liegen.

Eine maximale Stromstärke, die über die Kleinspannungsanschlüsse bereitgestellt werden kann, kann 40 Ampere betragen. Eine maximale Stromstärke, die über die Niederspannungsanschlüsse bereitgestellt werden kann, kann 75 Ampere betragen.

Durch die Niederspannungsleitung und Niederspannungsanschlüsse kann eine Niederspannung für die Funktionsmodule bereitgestellt werden.

Über die Datenanschlüsse kann ein Feldbus bereitgestellt werden, der der Kommunikation zwischen Basismodul und Funktionsmodulen dienen kann. Der Feldbus kann dabei als ein in der Norm IEC 61158 definierter Feldbus, insbesondere als EtherCAT, ausgestaltet sein.

Die Anschalteinheiten, die auch als Slaves bezeichnet werden können, sind durch den Datenbus miteinander verbunden und bilden ein Kommunikationsnetzwerk im Schaltschranksystem. Die Anschalteinheiten können also Daten miteinander austauschen. Über die mit den Anschlusselementen verbundenen Anschalteinheiten kann auch eine Kommunikation bzw. ein Datenaustausch zwischen dem Basismodul und Funktionsmodulen erfolgen. Alle Anschalteinheiten sind in dem Basismodul angeordnet. Dadurch bietet das Basismodul den Vorteil, dass im Fall eines Defekts oder eines Austauschs eines Funktionsmoduls alle noch intakten Funktionsmodule über den Datenbus angesprochen werden können. Aus diesem Grund kann außerdem ein Funktionsmodul im laufenden Betrieb eines Automatisierungssystems ausgetauscht werden. Darüber hinaus muss ein Automatisierungssystem nicht initialisiert werden, wenn ein konfiguriertes Funktionsmodul, das ein Funktionsmodul ersetzt, an das Basismodul angeschlossen wird. Wird das Automatisierungssystem beispielsweise in einer Produktionsmaschine eingesetzt, kann dies einen unerwünschten Produktionsausfall verhindern.

Dadurch können die Funktionalitäten, die traditionell mittels eines Schaltschranks bereitgestellt werden, mit einem solchen Basismodul und zugehörigen Funktionsmodulen bereitgestellt werden. Weitere Vorteile stellen der verminderte Verkabelungsaufwand und die einfachere Planung beziehungsweise Konzeptionierung eines solchen Schaltschranksystems dar.

Das Basisgehäuse beziehungsweise das Funktionsgehäuse kann als Stangenpressprofil oder als Druckgussgehäuse ausgeführt sein. Als Gehäusematerial kommen Metalle wie beispielsweise Aluminium, Stahl, Edelstahl oder Zink in Frage, wobei zusätzlich eine Beschichtung des Gehäuses vorgesehen sein kann.

Das Basisgehäuse beziehungsweise das Funktionsgehäuse kann aus mehreren Einzelteilen bestehen, die mittels Befestigungselementen, beispielsweise Schrauben, oder mittels Verschweißens oder Verlötens miteinander verbunden werden. Ferner kann eine Abdichtung zwischen den Einzelteilen vorgesehen sein, um das Basisgehäuse beziehungsweise das Funktionsgehäuse zwischen den Einzelteilen für Flüssigkeiten und/oder Staub unzugänglich zu machen.

Die Datenleitung, die Kleinspannungsleitung und die Niederspannungsleitung können innerhalb des Basisgehäuses auf einer oder mehreren Leiterkarten angeordnet sein. Insbesondere kann eine Leiterkarte für die Datenleitung und die Kleinspannungsleitung und eine weitere Leiterkarte für die Niederspannungsleitung vorgesehen sein. Die Datenleitung kann mehrere Adern aufweisen. Die Kleinspannungsleitung kann mehrere Adern aufweisen. Die Niederspannungsleitung kann mehrere Adern aufweisen. Wenn die Datenleitung, Kleinspannungsleitung beziehungsweise Niederspannungsleitung auf einer Leiterkarte angeordnet ist, können die Adern als Leiterbahnen auf der jeweiligen Leiterkarte ausgeführt sein.

Die Basisspannungsanschlüsse beziehungsweise die Basisdatenanschlüsse des Basismoduls beziehungsweise des Funktionsmoduls können als Steckverbinder und entsprechende Buchsen ausgestaltet sein. Alternativ können die Anschlusselemente eine Kabeleinführung und einen Klemmanschluss aufweisen.

Mittels mehrerer Funktionsmodule kann die Funktionalität eines Schaltschranks bereitgestellt werden, wobei die Funktionsmodule nicht unmittelbar miteinander verbunden werden, sondern eine Verbindung der Funktionsmodule über das Basismodul bereitgestellt wird.

Die Funktionsmodule innerhalb des Schaltschranksystems können als Eingangsmodule zum Auslesen von Sensordaten, als Ausgangsmodule zum Ausgeben von Spannungen, als SPS-Steuerungsmodule, als Motorsteuerungsmodule, als Netzteilmodule und/oder als Einspeisemodule ausgestaltet sein. Ein Einspeisemodul kann dabei die Aufgabe übernehmen, Daten, insbesondere in Form eines Feldbusses für das Basismodul bereitzustellen und/oder einer Spannungsversorgung des Basismoduls mit einer Kleinspannung und oder einer Niederspannung zu dienen. Ferner können Rechnermodule, Netzwerkswitchmodule, Servosteuerungsmodule, Netzfiltermodule, Schützmodule, Buskopplermodule, aktive oder passive Leistungsfaktorkorrekturmodule und/oder Frequenzumrichtermodule oder eine Kombination der genannten Module als Funktionsmodule ausgeführt sein.

Es kann vorgesehen sein, zusätzlich eine Dichtung zwischen dem Basismodul und den Funktionsmodulen anzubringen, um das System aus Basismodulen und Funktionsmodulen staub- und flüssigkeitsgeschützt auszuführen. Ein Schutz gegen Berühren kann bereits durch das Anbringen der Funktionsmodule am Basismodul erfolgen. Um die verschiedenen Aufgaben zu übernehmen, kann es vorgesehen sein, dass das Modulgehäuse auf einer der weiteren Modulgehäuseseiten weitere Anschlusselemente aufweist, die beispielsweise mit Sensoren, Aktoren oder anderen, typischerweise von einem Schaltschrank gesteuerten, Elementen verbunden sind.

Nach einem zweiten Aspekt, der nicht der beanspruchten Erfindung entspricht, wird ein Basismodul für ein Schaltschranksystem bereitgestellt, wobei das Basismodul ein Basisgehäuse mit einer ersten Gehäuseseite und einer zweiten Gehäuseseite aufweist, wobei an der ersten Gehäuseseite eine Mehrzahl von Basisanschlusselementen mit Basisspannungsanschlüssen und Basisdatenanschlüssen angeordnet ist, wobei im Basisgehäuse wenigstens eine Datenleitung mit einer Mehrzahl von Anschalteinheiten, die mit den Basisdatenanschlüssen der Basisanschlusselemente verbunden ist, und wenigstens eine Spannungsleitung angeordnet ist, die mit den Basisspannungsanschlüssen der Basisanschlusselemente verbunden ist, wobei im Basisgehäuse ein Zirkulationskanal angeordnet ist, wobei im Zirkulationskanal ein Luftstrom zirkulierbar ist, wobei jedes Basisanschlusselement Zirkulationsöffnungen aufweist, wobei die Zirkulationsöffnungen mit dem Zirkulationskanal fluidtechnisch verbunden sind, wobei die Zirkulationsöffnungen mit Kopplungsöffnungen eines Funktionsmoduls des Schaltschranksystems koppelbar sind, und wobei in einer Kopplung der Zirkulationsöffnungen mit Kopplungsöffnungen eines Funktionsmoduls eine fluidtechnische Verbindung zwischen dem Zirkulationskanal und einem Inneren des Funktionsgehäuses erzielbar ist und ein fluidtechnisch geschlossener Zirkulationskreislauf umfassend den Zirkulationskanal und das Innere des Funktionsgehäuses bildbar ist, in dem ein Luftstrom zirkulierbar ist.

Hierdurch wird der technische Vorteil erreicht, dass ein Basismodul für ein Schaltschranksystem mit den oben genannten Vorteilen bereitgestellt werden kann. Über den Zirkulationskanal innerhalb des Basisgehäuses des Basismoduls und den fluidtechnisch mit dem Zirkulationskanal verbundenen Zirkulationsöffnungen, die in die Basisanschlusselemente des Basismoduls integriert sind, kann mit entsprechenden Funktionsmodulen des Schaltschranksystems ein Zirkulationskreislauf erzeugt werden, der eine Zirkulation eines Luftvolumens innerhalb des Zirkulationskanals und innerhalb eines Funktionsgehäuses eines an das Basismodul angeschlossenen Funktionsmoduls und eine damit verbundene passive oder aktive Kühlung der elektronischen beziehungsweise elektrischen Komponenten des Funktionsmoduls erreicht werden.

Hierdurch kann ein Basismodul für ein staubdichtes und fluiddichtes Schaltschranksystem mit einer passiven oder aktiven Kühlung in Form eines in einem fluidtechnisch geschlossenen Zirkulationskreislauf zirkulierenden Luftstroms bereitgestellt werden.

Nach einem dritten Aspekt der Erfindung wird ein Funktionsmodul für ein Schaltschranksystem bereitgestellt, wobei das Funktionsmodul ein Funktionsgehäuse mit einer Gehäuseunterseite aufweist, wobei an der Gehäuseunterseite ein Funktionsanschlusselement mit Spannungsanschlüssen und Datenanschlüssen angeordnet ist, wobei im Funktionsgehäuse wenigstens eine elektronische Funktionsschaltung angeordnet ist, die mit den Spannungsanschlüssen und den Datenanschlüssen des Funktionsanschlusselements verbunden ist, wobei über eine Kopplung des Funktionsanschlusselements mit einem Basisanschlusselement eines Basismoduls des Schaltschranksystems das Funktionsmodul mit dem Basismodul verbindbar und eine Verbindung der Spannungsanschlüsse und Datenanschlüsse des Funktionsanschlusselements mit den Basisspannungsanschlüssen und Datenanschlüssen des Basiselements erzielbar ist, wobei das Funktionsanschlusselement Kopplungsöffnungen aufweist, wobei die Kopplungsöffnungen mit einem Inneren des Funktionsgehäuses fluidtechnisch verbunden sind, wobei die Kopplungsöffnungen mit Zirkulationsöffnungen eines Basismoduls des Schaltschranksystems koppelbar sind, und wobei in einer Kopplung der Kopplungsöffnungen mit den Zirkulationsöffnungen eine fluidtechnische Verbindung zwischen einem Zirkulationskanal des Basismoduls und dem Inneren des Funktionsgehäuses erzielbar ist und ein fluidtechnisch geschlossener Zirkulationskreislauf umfassend den Zirkulationskanal und das Innere des Funktionsgehäuses bildbar ist, in dem ein Luftstrom zirkulierbar ist.

Hierdurch wird der technische Vorteil erreicht, dass ein Funktionsmodul für ein Schaltschranksystem mit den oben genannten Vorteilen bereitgestellt werden kann. Über die in den Funktionsanschlusselementen des Funktionsmoduls integrierten Kopplungsöffnungen, die fluidtechnisch mit einem Inneren des Funktionsgehäuses des Funktionsmoduls verbunden sind, kann mittels einer Kopplung der Kopplungsöffnungen mit Zirkulationsöffnungen eines Basisanschlusselements eines Basismoduls des Schaltschranksystems eine fluidtechnische Verbindung des Inneren des Funktionsgehäuses des Funktionsmoduls mit dem Zirkulationskanal des Basismoduls erreicht werden und somit eine Integration des Inneren des Funktionsgehäuses des Funktionsmoduls in den fluidtechnischen Zirkulationskreislauf des Schaltschranksystems erzielt werden, wodurch eine Zirkulation des Luftvolumens innerhalb des Funktionsgehäuses des Funktionsmoduls erzielt und eine damit verbundene passive oder aktive Kühlung der elektronischen wie auch elektrischen Komponente des Funktionsmoduls bewirkt werden kann.

Hierdurch kann ein Funktionsmodul für ein staubdichtes und fluiddichtes Schaltschranksystem mit einer passiven oder aktiven Kühlung in Form eines in einem fluidtechnisch geschlossenen Zirkulationskreislauf zirkulierenden Luftstroms bereitgestellt werden.

Nach einer Ausführungsform umfasst das Schaltschranksystem ferner ein Ventilatorelement, wobei das Ventilatorelement in den fluidtechnischen Zirkulationskreislauf integriert ist, und wobei das Ventilatorelement ausgebildet ist, innerhalb des Zirkulationskreislaufs den zirkulierenden Luftstrom zu beschleunigen.

Hierdurch wird der technische Vorteil erreicht, dass die Zirkulation des Luftstroms innerhalb des Zirkulationskanals verbessert werden kann. Durch den Betrieb eines im Zirkulationskreislauf des Schaltschranksystems angeordneten Ventilatorelements kann die Zirkulationsgeschwindigkeit des im Zirkulationskreislauf zirkulierenden Luftstroms erhöht werden. Hierdurch kann eine Verwirbelung des Luftvolumens im Inneren eines Funktionsgehäuses eines Funktionsmoduls des Schaltschranksystems erhöht werden, wodurch eine Zerstreuung möglicher Wärmestaunester verbessert werden kann. Hierdurch kann eine abgeschlossene aktive Kühlung erzielt und der Kühleffekt innerhalb des Schaltschranksystems erhöht werden. Durch eine erhöhte Zirkulation des Luftvolumens innerhalb des Funktionsgehäuses eines Funktionsmoduls des Schaltschranksystems kann eine Bildung von Wärmestaunestern vermieden beziehungsweise gebildete Wärmestaunester zerstört werden und die darin entstandene Wärme in den Zirkulationskanal des Basismoduls abtransportiert werden.

Eine abgeschlossene aktive Kühlung ist im Sinne der Anmeldung eine Kühlung, bei der kein Austausch von Kühlmittel zwischen der Umgebung und dem zu kühlenden System stattfindet.

Nach einer Ausführungsform ist das Ventilatorelement im Funktionsgehäuse des Funktionsmoduls und/oder innerhalb des Zirkulationskanals des Basismoduls angeordnet.

Hierdurch wird der technische Vorteil erreicht, dass eine Flexibilität der Ausgestaltung des Kühlungssystems ermöglicht ist. Je nach Anforderung an das Schaltschranksystem kann das Ventilatorelement innerhalb eines Funktionsgehäuses eines Funktionsmoduls und/oder innerhalb des Zirkulationskanals des Basismoduls angeordnet sein. Für den Fall, dass aufgrund der Anwendung ein Basismodul benötigt wird, das einen geringen Platzbedarf aufweist, kann somit das Ventilatorelement in einem Funktionsgehäuse eines Funktionsmoduls des Schaltschranksystems angeordnet werden. Für den Fall, dass Funktionsmodule mit möglichst geringem Platzbedarf benötigt werden, kann auf der anderen Seite das Ventilatorelement innerhalb des Zirkulationskanals des Basismoduls angeordnet werden. Alternativ kann das Schaltschranksystem auch mit einer Mehrzahl von Ventilatorelementen vorgesehen sein, indem entweder eine Mehrzahl von Ventilatorelementen innerhalb des Zirkulationskanals des Basismoduls angeordnet wird, oder Ventilatorelemente sowohl innerhalb des Zirkulationskanals als auch innerhalb von Funktionsgehäusen eines oder einer Mehrzahl von Funktionsmodulen des Schaltschranksystems angeordnet werden. Hierdurch kann je nach Anwendungsbedarf eine individuell gestaltbare Kühlung bereitgestellt werden.

Insbesondere kann durch eine Mehrzahl von Funktionsmodulen, die jeweils über Ventilatorelemente verfügen, eine Bewegung des zirkulierenden Luftstroms und ein damit verbundener Kühleffekt beliebig skaliert werden, indem bei gesteigertem Kühlbedarf weitere Funktionsmodule mit weiteren Ventilatorelementen an das Basismodul angeschlossen werden, während diese bei einem verringerten Kühlbedarf vom Basismodul entfernt werden können. Alternativ können Funktionsmodule auch als Kühlmodule ausgestaltet sein, wobei die Kühlmodule über keine Funktionsschaltung verfügen und lediglich mit einem oder mehreren Ventilatorelementen ausgestaltet sind. Kühlmodule dienen im Schaltschrank somit ausschließlich zum Antrieb des Luftstroms innerhalb beziehungsweis entlang des Zirkulationskreislaufs.

Nach einer Ausführungsform sind an den Zirkulationsöffnungen Regulierungsmittel angeordnet, wobei die Regulierungsmittel ausgebildet sind, ein Volumen eines durch die Zirkulationsöffnungen strömenden Luftstroms zu regulieren.

Hierdurch wird der technische Vorteil erreicht, dass eine gleichmäßige Anbindung einer Mehrzahl von Funktionsmodulen an den Zirkulationskreislauf gewährleistet werden kann. Bei einer Verbindung einer Mehrzahl von Funktionsmodulen an ein Basismodul, die jeweils in einer Strömungsrichtung des zirkulierenden Luftstroms innerhalb des Zirkulationskanals des Basismoduls nacheinander über die entsprechenden Anschlusselemente und die darin verbundenen Kopplungsöffnungen beziehungsweise Zirkulationsöffnungen an den Zirkulationskanal angeschlossen sind, kann über die Mehrzahl von Regulierungsmitteln, die an den entsprechenden Zirkulationsöffnungen angeordnet sind, der Luftstrom, der aus dem Zirkulationskanal in das Innere eines Funktionsgehäuses eines an das Basismodul angeschlossenen Funktionsmoduls derart reguliert werden, dass in Strömungsrichtung des Luftstroms innerhalb des Zirkulationskanals untereinander angeordneter Funktionsmodule jedes Funktionsmodul mit einem ausreichenden Luftstrom versorgt ist. Alternativ kann auch eine Regulierung des aus dem Funktionsgehäuse in den Zirkulationskanal strömenden Luftstroms erreicht werden.

Hierdurch kann gewährleistet werden, dass für jedes am Basismodul angeschlossene Funktionsmodul eine identische Durchströmung des jeweiligen Funktionsgehäuses mit einem zirkulierenden Luftstrom und damit verbunden ein identischer Kühleffekt erreicht werden kann, sodass eine Positionierung der einzelnen Funktionsmodule auf dem Basismodul keinerlei Einfluss auf die erreichte Kühlleistung innerhalb des jeweiligen Funktionsgehäuses des Funktionsmoduls hat. Somit kann eine gleichmäßige Kühlung für eine Mehrzahl von Funktionsmodulen gewährleistet werden.

Nach einer Ausführungsform weist jede Kopplungsöffnung jeweils einen Kopplungskragen auf, wobei der Kopplungskragen die Kopplungsöffnung umgibt und von dem Funktionsanschlusselement hervorsteht, wobei der Kopplungskragen in eine Zirkulationsöffnung einführbar ist und eine Kopplung zwischen der Kopplungsöffnung und der Zirkulationsöffnung ermöglicht, und wobei durch die Kopplung zwischen den Kopplungsöffnungen und den Zirkulationsöffnungen eine fluiddichte Verbindung zwischen dem Funktionsmodul und dem Basismodul erreicht ist.

Hierdurch wird der technische Vorteil erreicht, dass eine fluiddichte Verbindung zwischen einem Funktionsmodul und dem Basismodul des Schaltschranksystems über eine Verbindung des Funktionsanschlusselements mit einem entsprechenden Basisanschlusselement erzielt werden kann. Über das Einführen der Kopplungskragen einer jeden Kopplungsöffnung eines Funktionsanschlusselements eines Funktionsmoduls in die jeweiligen Zirkulationsöffnungen eines Basisanschlusselements des Basismoduls kann eine fluiddichte Verbindung zwischen den Kopplungsöffnungen und den entsprechenden Zirkulationsöffnungen der jeweiligen Anschlusselemente erreicht werden. Durch das Einführen des Kopplungskragens in eine entsprechende Zirkulationsöffnung kann somit die Fluiddichtigkeit des Schaltschranksystems gewährleistet werden. Darüber hinaus erleichtern die vom jeweiligen Funktionsanschlusselement hervorstehenden Kopplungskrägen eine Verbindung des jeweiligen Funktionsmoduls mit dem Basismodul, indem die entsprechenden Kopplungskrägen in die jeweiligen Zirkulationsöffnungen eines entsprechenden Basisanschlusselements eingeführt werden.

Nach einer Ausführungsform sind an den Zirkulationsöffnungen Dichtungsmittel angeordnet, wobei die Dichtungsmittel ausgebildet sind, die Zirkulationsöffnungen der Basisanschlusselemente fluidtechnisch zu verschließen, an denen keine Funktionsmodule angeschlossen sind.

Hierdurch wird der technische Vorteil erreicht, dass ein fluiddichter Abschluss des Zirkulationskanals des Basismoduls gegenüber der das Schaltschranksystem umgebenden Umgebungsluft erreicht wird. Über die Dichtungsmittel die an den Zirkulationsöffnungen der Basisanschlusselemente des Basismoduls angeordnet sind, können die Zirkulationsöffnungen, an die keine Kopplungsöffnungen eines Funktionsmoduls angeschlossen sind, gegenüber der Umgebungsluft des Schaltschranksystems fluiddicht abgeschlossen werden. Hiermit kann erreicht werden, dass auch bei nicht vollständiger Belegung aller Basisanschlusselemente des Basismoduls durch entsprechende Funktionsmodule der Zirkulationskanal fluiddicht in Bezug auf die das Schaltschranksystem umgebende Umgebungsluft abgeschlossen ist.

Nach einer Ausführungsform sind im Inneren des Funktionsgehäuses des Funktionsmoduls Führungsmittel angeordnet, wobei die Führungsmittel ausgebildet sind, einen durch die Kopplungsöffnungen in das Innere des Funktionsgehäuses strömenden Luftstrom in einen vorbestimmten Bereich innerhalb des Funktionsgehäuses zu führen.

Hierdurch wird der technische Vorteil erreicht, dass eine Zirkulation innerhalb des Funktionsgehäuses eines an das Basismodul angeschlossenen Funktionsmoduls verstärkt werden kann. Über entsprechende Führungsmittel, die innerhalb des Funktionsgehäuses angeordnet sind und ausgebildet sind, den durch Kopplungsöffnungen des Funktionsanschlusselements des Funktionsmoduls strömenden Luftstrom in entsprechende Bereiche innerhalb des Funktionsgehäuses zu leiten. Diese Bereiche können beispielsweise Bereiche sein, in denen Komponenten der elektronischen Funktionsschaltung angeordnet sind, die eine hohe Wärmeentwicklung aufweisen. Darüber hinaus können die Führungsmittel ausgebildet sein, den Luftstrom in möglichst umfassende Bereiche des Funktionsgehäuses zu leiten, sodass ein möglichst großer Anteil der Komponenten der elektronischen Funktionsschaltung von dem durch das Funktionsgehäuse strömenden Luftstrom umströmt werden. Hierdurch kann eine möglichst effektive Zirkulation des Luftvolumens innerhalb des Funktionsgehäuses erreicht werden, wodurch eine möglichst effiziente Verwirbelung möglicher Wärmestaunester und damit verbunden eine möglichst effiziente Kühlung der elektronischen Funktionsschaltung innerhalb des Funktionsgehäuses des Funktionsmoduls erreicht werden kann. Darüber hinaus können die Funktionsmittel auch eingerichtet sein, den Luftstrom innerhalb des Funktionsgehäuses zu beschleunigen, wodurch ebenfalls eine weitere Steigerung des Kühleffekts beziehungsweise der Kühlleistung erreicht werden.

Nach einer Ausführungsform umfassen die Führungsmittel an den Kopplungsöffnungen angeordnete Führungsdüsen, die geeignet sind, den Luftstrom in den vorbestimmten Bereich innerhalb des Funktionsgehäuses zu führen.

Hierdurch wird der technische Vorteil erreicht, dass eine möglichst einfache Ausgestaltung der Führungsmittel erreicht ist. Die an den Kopplungsöffnungen angeordneten Funktionsdüsen können hierbei möglichst platzsparend ausgebildet sein, sodass innerhalb des Funktionsgehäuses durch die Führungsmittel ein möglichst geringer Bauraum beansprucht wird. Darüber hinaus kann eine möglichst robuste Ausgestaltung der Führungsmittel in Form der Führungsdüsen erreicht werden. Durch die Ausgestaltung der Führungsdüsen kann eine präzise und gerichtete Führung des Luftstroms innerhalb des Funktionsgehäuses erreicht werden. Die Führungsdüsen stellen ferner eine technisch einfache Lösung der Führungsmittel dar.

Nach einer Ausführungsform umfassen die Führungsmittel ein im Inneren des Gehäuses angeordnetes Führungsventilatorelement.

Hierdurch wird der technische Vorteil erreicht, dass eine effiziente Zirkulation des Luftvolumens innerhalb des Funktionsgehäuses bereitgestellt werden kann. Über das Führungsventilatorelement, das innerhalb des Funktionsgehäuses angeordnet ist, kann der durch die Kopplungsöffnungen strömende Luftstrom effizient im Inneren des Funktionsgehäuses verteilt werden, wodurch eine effektive und effiziente Verwirbelung möglicher Wärmestaunester ermöglicht ist. Darüber hinaus kann über das Führungsventilatorelement eine Geschwindigkeit des durch die Kopplungsöffnungen strömenden Luftstroms erhöht werden, wodurch eine Verwirbelung des Luftvolumens innerhalb des Funktionsgehäuses weiter verstärkt werden kann, wodurch wiederum eine weitere Steigerung des Kühleffekts erzielt werden kann. Das Führungsventilatorelement stellt ferner eine technisch einfache Lösung der Führungsmittel dar. Alternativ kann in einem Funktionsgehäuse eine Mehrzahl von Führungsventilatorelementen ausgebildet sein.

Nach einer Ausführungsform umfassen die Führungsmittel einen Führungskanal, wobei der Führungskanal eine fluidtechnische Verbindung zu wenigstens einer der Kopplungsöffnungen aufweist, und wobei der Führungskanal ausgebildet ist, den Luftstrom in einen vorbestimmten Bereich innerhalb des Inneren des Funktionsgehäuses zu führen.

Hierdurch wird der technische Vorteil erreicht, dass eine technisch möglichst einfache Ausgestaltung der Führungsmittel in Form eines oder mehrerer Führungskanäle, die an die jeweiligen Kopplungsöffnungen angeschlossen sind, bereitgestellt werden kann. Die Führungskanäle können hierbei den durch die Kopplungsöffnungen strömenden Luftstrom in die entsprechenden Bereiche innerhalb des Funktionsgehäuses leiten, in denen beispielsweise Komponenten der Funktionsschaltung angeordnet sind, die eine möglichst starke Wärmeentwicklung aufweisen. Alternativ kann der Luftstrom über den Führungskanal beziehungsweise die Führungskanäle in einen möglichst umfassenden Bereich innerhalb des Funktionsgehäuses geleitet werden, sodass ein möglichst großer Anteil der Komponenten der elektronischen Funktionsschaltung von dem Luftstrom umströmt wird. Hierdurch kann eine individuelle und verbesserte Kühlleistung erzielt werden.

Alternativ kann in einem Funktionsgehäuse auch eine Kombination von Führungsdüsen, Führungsventilatorelementen und Führungskanälen ausgebildet sein.

Nach einer Ausführungsform steht der Zirkulationskanal in einem thermischen Kontakt mit wenigstens einer Gehäuseinnenwand des Basisgehäuses des Basismoduls.

Hierdurch wird der technische Vorteil erreicht, dass eine weitere Kühlung des Luftvolumens des Zirkulationskreislaufs bereitgestellt werden kann. Über den thermischen Kontakt des Zirkulationskanals mit wenigstens einer Gehäuseinnenwand des Basisgehäuses des Basismoduls kann der Zirkulationskanal die Wärme innerhalb des durch den Zirkulationskanal strömenden Luftstroms aufnehmen und an die Gehäuseinnenwand des Basisgehäuses abgeben. Hierdurch kann ein Kühleffekt des Luftstroms innerhalb des Zirkulationskreislaufs erreicht werden. Durch die Kühlung des Luftstroms innerhalb des Zirkulationskanals kann somit eine gesteigerte Kühlleistung innerhalb der an das Basismodul angeschlossenen Funktionsmodule erreicht werden, indem die während des Durchströmens des Luftstroms durch die Funktionsgehäuse der angeschlossenen Funktionsmodule aufgenommene Wärmemenge, die von den Komponenten der elektronischen Funktionsschaltungen der Funktionsmodule erzeugt wird, über den von den Funktionsmodulen in den Zirkulationskanal des Basismoduls strömenden Luftstrom an das Gehäuse des Basismoduls abgegeben wird, wodurch eine Steigerung der Kühlwirkung des die Komponenten der Funktionsschaltungen der an das Basismodul angeschlossenen Funktionsmodule umströmenden Luftstroms erzielt wird.

Nach einer Ausführungsform umfasst der Zirkulationskanal einen ersten Teilkanal, einen zweiten Teilkanal, einen dritten Teilkanal und einen vierten Teilkanal, wobei der erste Teilkanal und der zweite Teilkanal parallel zueinander angeordnet sind, wobei der dritte Teilkanal und der vierte Teilkanal parallel zueinander angeordnet sind, wobei jedes Basisanschlusselement eine erste Zirkulationsöffnung und eine zweite Zirkulationsöffnung aufweist, wobei die erste Zirkulationsöffnung mit dem ersten Teilkanal und die zweite Zirkulationsöffnung mit dem zweiten Teilkanal fluidtechnisch verbunden sind, wobei das Funktionsanschlusselement eine erste Kopplungsöffnung und eine zweite Kopplungsöffnung aufweist, wobei die erste Kopplungsöffnung und die zweite Kopplungsöffnung jeweils fluidtechnisch mit einem Inneren des Funktionsgehäuses verbunden sind, wobei die erste Kopplungsöffnung mit der ersten Zirkulationsöffnung und die zweite Kopplungsöffnung mit der zweiten Zirkulationsöffnung koppelbar sind, und wobei durch den zirkulierenden Luftstrom zwischen dem ersten Teilkanal und dem zweiten Teilkanal eine Druckdifferenz erzielbar ist.

Hierdurch wird der technische Vorteil erreicht, dass eine weitere Steigerung der Kühlleistung der passiven oder abgeschlossenen aktiven Kühlung des Schaltschranksystems erreicht werden kann. Durch die Ausgestaltung des Zirkulationskanals mit einem ersten Teilkanal, einem zweiten Teilkanal, einem dritten Teilkanal und einem vierten Teilkanal, wobei jeweils die ersten und zweiten Teilkanäle und die dritten und vierten Teilkanäle parallel zueinander angeordnet sind, kann eine möglichst einfache Ausgestaltung des Zirkulationskanals erreicht werden. Hierdurch wird eine Fertigung des Basismoduls vereinfacht. Durch die Zirkulation des Luftstroms innerhalb des Zirkulationskanals in einer vorbestimmten Zirkulationsrichtung kann darüber hinaus eine Druckdifferenz zwischen dem ersten Teilkanal und dem zweiten Teilkanal erreicht werden.

Durch die Ausbildung der Zirkulationsöffnungen als erste Zirkulationsöffnungen und zweite Zirkulationsöffnungen, wobei erste Zirkulationsöffnungen in fluidtechnischer Verbindung mit dem ersten Zirkulationskanal und zweite Zirkulationsöffnungen in fluidtechnischer Verbindung mit dem zweiten Zirkulationskanal stehen, kann erreicht werden, dass entsprechend der Druckdifferenz zwischen dem ersten Teilkanal und dem zweiten Teilkanal ein Luftstrom aus dem Zirkulationskanal durch die ersten Zirkulationsöffnungen beziehungsweise durch die zweiten Zirkulationsöffnungen ausströmt. Bei Anschluss eines Funktionsmoduls an das Basismodul kann somit erreicht werden, dass je nach Druckdifferenz zwischen dem ersten Teilkanal und dem zweiten Teilkanal ein Luftstrom aus dem Zirkulationskanal durch die ersten Zirkulationsöffnungen in das Funktionsgehäuse einströmt, aus dem der Luftstrom durch die zweiten Kopplungsöffnungen beziehungsweise Zirkulationsöffnungen in den zweiten Teilkanal des Zirkulationskanals wieder einströmt.

Hierdurch kann eine vorbestimmte Zirkulation des Luftvolumens innerhalb des Funktionsgehäuses des an das Basismodul angeschlossenen Funktionsmoduls von den ersten Kopplungsöffnungen in Richtung der zweiten Kopplungsöffnungen geleitet werden, indem durch die erzeugte Druckdifferenz zwischen dem ersten Teilkanal und dem zweiten Teilkanal der Luftstrom des Zirkulationskanals durch die ersten Kopplungsöffnungen in das Innere des Funktionsgehäuses eintritt und durch die zweiten Kopplungsöffnungen aus dem Funktionsgehäuse in den zweiten Teilkanal des Basismoduls eintritt. Hierdurch kann eine effektive und effiziente Verwirbelung des Luftvolumens innerhalb des Funktionsgehäuses des an das Basismodul angeschlossenen Funktionsmoduls und eine damit verbundene Kühlung der Komponenten der elektronischen Funktionsschaltung des Funktionsmoduls erreicht werden.

Nach einer Ausführungsform sind die erste Kopplungsöffnung und die zweite Kopplungsöffnung an zwei gegenüberliegenden äußersten Enden des Funktionsanschlusselements angeordnet, und wobei die Datenanschlüsse und Spannungsanschlüsse am Funktionsanschlusselement zwischen der ersten Kopplungsöffnung und der zweiten Kopplungsöffnung angeordnet sind.

Hierdurch wird der technische Vorteil erreicht, dass ein möglichst breiter Abstand der ersten und zweiten Kopplungsöffnungen des Funktionsmoduls erzielt wird, wodurch gewährleistet werden kann, dass der durch die ersten Kopplungsöffnungen in das Funktionsgehäuse eintretende und durch die zweiten Kopplungsöffnungen aus dem Funktionsgehäuse austretende Luftstrom einen möglichst breiten Bereich der im Funktionsgehäuse angeordneten elektronischen Funktionsschaltung umströmt. Hierdurch wird eine gesteigerte Kühlwirkung erreicht.

Nach einer Ausführungsform umfasst das Schaltschranksystem ferner ein Heizelement, wobei das Heizelement in den fluidtechnischen Zirkulationskreislauf integriert ist, wobei das Heizelement eingerichtet ist, ein vom Zirkulationskreislauf umfasstes Luftvolumen zu heizen, und wobei das Heizelement innerhalb des Funktionsgehäuses des Funktionselements und/oder innerhalb des Zirkulationskanals angeordnet ist.

Hierdurch wird der technische Vorteil erreicht, dass eine Kondensation einer Luftfeuchtigkeit des im Zirkulationskreislauf befindlichen Luftvolumens vermieden werden kann. Insbesondere kann während eines Zeitraums eines Nichtbetriebs des Schaltschranksystems durch einen Betrieb des Heizelements eine konstante Temperatur des im Zirkulationskreislauf befindlichen Luftvolumens gewährleistet werden, sodass eine Kondensation der im Luftvolumen befindlichen Luftfeuchtigkeit vermieden werden kann. Hierdurch kann eine Schädigung der elektronischen und elektrischen Komponenten der Funktionsschaltung der an das Basismodul angeschlossenen Funktionsmodule aufgrund einer Kondensation der Luftfeuchtigkeit des in den Funktionsgehäusen befindlichen Luftvolumens vermieden werden, indem eine Temperatur des Luftvolumens durch Betrieb des Heizelements konstant oberhalb einer Kondensationstemperatur des Luftvolumens erhalten werden kann.

Nach einer Ausführungsform umfasst das Schaltschranksystem ferner einen Wärmetauscher, wobei der Wärmetauscher in den Zirkulationskreislauf integriert ist, wobei der Wärmetauscher eingerichtet ist, den Luftstrom innerhalb des Zirkulationskreislaufs zu kühlen, wobei der Wärmetauscher ein Luft-Luft-Wärmetauscher oder ein Luft-Wasser-Wärmetauscher ist, und wobei der Wärmetauscher im Inneren des Funktionsgehäuses des Funktionsmoduls und/oder im Inneren des Basisgehäuses des Basismoduls angeordnet ist.

Hierdurch wird der technische Vorteil erreicht, dass eine weitere Steigerung der Kühlleistung der passiven oder abgeschlossenen aktiven Kühlung des Schaltschranksystems erzielt werden kann. Über die Anordnung eines Wärmetauschers innerhalb des Zirkulationskreislaufs kann eine weitere Kühlung des im Zirkulationskreislauf befindlichen Luftvolumens erreicht werden. Hierdurch kann erreicht werden, dass das gekühlte Luftvolumen des Zirkulationskreislaufs eine größere Wärmemenge der von den Komponenten der Funktionsschaltungen der an das Basismodul angeschlossenen Funktionsmodule erzeugten Wärme aufgenommen werden kann.

Indem der Wärmetauscher innerhalb des Zirkulationskanals des Basismoduls oder innerhalb eines Funktionsgehäuses eines Funktionsmoduls des Schaltschranksystems angeordnet ist, kann eine möglichst flexible Ausgestaltung des Schaltschranksystems erreicht werden, indem je nach Anforderungen an den Bauraum des Schaltschranksystems der Wärmetauscher in dem Modul des Schaltschranksystems angeordnet werden kann, das eine Anordnung auf Basis des benötigten Bauraums zulässt. Hierdurch kann ein Schaltschranksystem mit möglichst geringen Ausmaßen bereitgestellt werden. Darüber hinaus können mehrere Wärmetauscher innerhalb des Zirkulationskanals des Basismoduls beziehungsweise innerhalb mehrerer Funktionsgehäuse verschiedener Funktionsmodule angeordnet werden, wodurch eine weitere Steigerung der Kühlleistung der passiven oder abgeschlossenen aktiven Kühlung des Schaltschranksystems erreicht wird.

Alternativ kann der Wärmetauscher auch im Funktionsgehäuse eines Kühlmoduls eingerichtet sein, wobei das Kühlmodul ein Funktionsmodul ist, das lediglich zur Kühlung des Luftvolumens innerhalb des Zirkulationskreislauf dient und keine elektronische Funktionsschaltung aufweist.

Nach einer Ausführungsform sind an der zweiten Gehäuseseite des Basisgehäuses des Basismoduls Kühlrippen und/oder eine Wasserkühlung ausgebildet, und/oder wobei an einer Gehäusefläche des Funktionsmoduls Kühlrippen ausgebildet sind.

Hierdurch wird der technische Vorteil erreicht, dass eine weitere Steigerung der Kühlleistung der passiven oder abgeschlossenen aktiven Kühlung des Schaltschranksystems ermöglicht ist. Über die Anordnung von Kühlrippen an einer zweiten Gehäuseseite des Basisgehäuses und/oder durch eine Anordnung einer Wasserkühlung an der zweiten Gehäuseseite des Basisgehäuses und/oder durch eine Anordnung weiterer Kühlrippen am Funktionsgehäuse des Funktionsmoduls kann erreicht werden, dass innerhalb des Basisgehäuses des Basismoduls beziehungsweise innerhalb der Funktionsgehäuse der an das Basismodul angeschlossenen Funktionsmodule entstandene Wärme über das jeweilige Basisgehäuse beziehungsweise Funktionsgehäuse an die das Schaltschranksystem umgebende Umgebungsluft abgegeben werden kann. Über die Anordnung der Kühlrippen an den jeweiligen Gehäuseseiten wird die Abgabe der Wärme über das jeweilige Gehäuse an die Umgebungsluft gesteigert. Analog bewirkt eine Wasserkühlung am Basisgehäuse eine Steigerung der Abgabe der innerhalb des Basisgehäuses entstandenen Wärme über das Basisgehäuse an die das Schaltschranksystems umgebende Umgebungsluft.

Nach einer Ausführungsform ist an der dritten Gehäusefläche des Basismoduls ein externes Lüfterelement ausgebildet, wobei das externe Lüfterelement eingerichtet ist, Kühlluft entlang der Kühlrippen zu führen, und/oder wobei an einer weiteren Gehäusefläche des Funktionsmoduls ein weiteres externes Lüfterelement ausgebildet ist, wobei das weitere externe Lüfterelement eingerichtet ist, Kühlluft entlang der weiteren Kühlrippen zu führen.

Hierdurch wird der technische Vorteil erreicht, dass eine weitere Steigerung der Kühlleistung der passiven oder abgeschlossenen aktiven Kühlung des Schaltschranksystems erzielt werden kann. Über die Ausbildung externer Lüfterelemente, die an Außenflächen des Basisgehäuses des Basismoduls beziehungsweise der Funktionsgehäuse der Funktionsmodule angeordnet sind und ausgerichtet sind, einen Luftstrom entlang der an dem Basisgehäuse beziehungsweise den Funktionsgehäusen ausgebildeten Kühlrippen zu führen, kann eine weitere Steigerung der Abgabe der in dem Basisgehäuse beziehungsweise den Funktionsgehäusen entstandenen Wärme über die jeweiligen Gehäuse an die das Schaltschranksystem umgebende Umgebungsluft erreicht werden.

Nach einer Ausführungsform ist im Inneren des Funktionsgehäuses ein internes Lüfterelement angeordnet, wobei das interne Lüfterelement eingerichtet ist, Kühlluft entlang wenigstens einer Innenwand des Funktionsgehäuses zu führen, und/oder wobei in einem Inneren des Basisgehäuses ein weiteres internes Lüfterelement angeordnet ist, wobei das weitere interne Lüfterelement eingerichtet ist, Kühlluft entlang wenigstens einer Innenwand des Basisgehäuses zu führen.

Hierdurch wird der technische Vorteil erreicht, dass eine weitere Steigerung der Kühlleistung der passiven oder abgeschlossenen aktiven Kühlung des Schaltschranksystems erzielt werden kann. Über die Ausbildung interner Lüfterelemente, die innerhalb das Basisgehäuses des Basismoduls und/oder innerhalb der Funktionsgehäuse der an das Basismodul angeschlossenen Funktionsmodule angeordnet sind, und die ausgebildet sind, einen kühlenden Luftstrom an die Innenwände der jeweiligen Gehäuse zu führen, kann keine Kühlung des Basisgehäuses beziehungsweise der Funktionsgehäuse erreicht werden, wodurch wiederum eine Kühlung des innerhalb des Zirkulationskreislaufs befindlichen Luftvolumens über eine Abgabe der innerhalb des Luftvolumens befindlichen Wärme an das gekühlte Basisgehäuse beziehungsweise Funktionsgehäuse erreicht werden kann. Durch die Kühlung des Luftvolumens innerhalb des Zirkulationskreislaufs wird eine Fähigkeit des Luftvolumens zur Aufnahme von Wärme der Komponenten der Funktionsschaltungen der Funktionsmodule gesteigert, wodurch eine Erhöhung der Kühlleistung des Zirkulationskreislaufs und der damit verbundenen passiven oder abgeschlossenen aktiven Kühlung des Schaltschranksystems erreicht wird.

Nach einer Ausführungsform weisen Bauteile der elektrischen Schaltung des Funktionsmoduls einen thermischen Kontakt zu einer Gehäuseinnenwand des Funktionsgehäuses auf.

Hierdurch wird der technische Vorteil erreicht, dass eine direkte Kühlung der Komponenten der elektronischen Funktionsschaltungen der an das Basismodul angeschlossenen Funktionsmodule erreicht wird. Über thermische Kopplungen der einzelnen Komponenten der Funktionsschaltungen an Innenwände der jeweiligen Funktionsgehäuse kann direkt eine durch den Betrieb der Funktionsschaltung entstandene Wärme über das Funktionsgehäuse an die das Schaltschranksystem umgebende Umgebungsluft erreicht werden. Hierdurch kann eine weitere Steigerung der Kühlleistung der passiven oder abgeschlossenen aktiven Kühlung des Schaltschranksystems bewirkt werden.

Nach einer Ausführungsform ist das Funktionsgehäuse und/oder das Basisgehäuse aus einem Material mit einer Wärmeleitfähigkeit von wenigstens 10 W/mK gefertigt.

Hierdurch wird der technische Vorteil erreicht, dass eine möglichst hohe Abgabe der in dem Basisgehäuse beziehungsweise den Funktionsgehäusen entstanden Wärme über die jeweiligen Gehäusewände an die Umgebung des Schaltschranksystems erzielt werden kann. Hierzu können die einzelnen Gehäuse der Module des Schaltschranksystems aus einer vorteilhaften Metalllegierung gefertigt werden, die eine hohe Wärmeleitfähigkeit aufweist und somit eine hohe Wärmemenge an die Umgebung des Schaltschranksystems abstrahlen kann. Hierdurch wird die Kühlleistung der passiven oder abgeschlossenen aktiven Kühlung des Schaltschranksystems weiter erhöht.

Nach einer Ausführungsform ist das Funktionsgehäuse und/oder das Basisgehäuse mit einer Beschichtung mit einer Wärmeleitfähigkeit von wenigstens 10 W/mK beschichtet.

Hierdurch wird eine weitere Erhöhung der Kühlleistung der passiven oder abgeschlossenen aktiven Kühlung des Schaltschranksystems erzielt. Über eine entsprechende Beschichtung der Gehäusewände der einzelnen Module des Schaltschranksystems kann die Wärmeleitfähigkeit der einzelnen Gehäuse der Module des Schaltschranksystems weiter erhöht werden, wodurch eine weitere Steigerung der Abstrahlung der in den jeweiligen Gehäusen befindlichen Wärme über die Gehäusewände an die Umgebung des Schaltschranksystems erzielt werden kann.

Bei der Erfindung kann ein Merkmal positiv, d. h. vorhanden, oder negativ, d. h. abwesend, ausgestaltet sein, wobei ein negatives Merkmal als Merkmal nicht explizit erläutert ist, wenn nicht nach der Erfindung Wert daraufgelegt ist, dass es abwesend ist, also die tatsächlich gemachte und nicht eine durch den Stand der Technik konstruierte Erfindung darin besteht, dieses Merkmal wegzulassen.

Die Merkmale der Beschreibung sind auch als optionale Merkmale interpretierbar; d. h. ein jedes nicht in den unabhängigen Ansprüchen aufgeführte Merkmal kann als ein fakultatives, arbiträres oder bevorzugtes, also als ein nicht verbindliches, Merkmal aufgefasst werden. Das Fehlen eines Merkmals in einem Ausführungsbeispiel zeigt, dass das Merkmal in Bezug auf die Erfindung optional ist, sofern das Merkmal nicht in den unabhängigen Ansprüchen aufgeführt ist.

In den Figuren zeigen:
- Fig. 1: eine perspektivische schematische Ansicht eines Schaltschranksystems gemäß einer Ausführungsform;
- Fig. 2: eine weitere perspektivische schematische Ansicht eines Schaltschranksystems gemäß einer weiteren Ausführungsform;
- Fig. 3: eine schematische Draufsicht eines Basismoduls gemäß einer Ausführungsform;
- Fig. 4: eine weitere schematische Draufsicht eines Basismoduls gemäß einer weiteren Ausführungsform;
- Fig. 5: eine perspektivische schematische Ansicht eines Funktionsmoduls gemäß einer Ausführungsform;
- Fig. 6: eine schematische Bodenansicht des Funktionsmoduls in Fig. 5;
- Fig. 7: eine schematische Innenansicht des Funktionsmoduls in Fig. 5;
- Fig. 8: eine schematische Schnittansicht entlang einer Schnittachse A des Schaltschranksystems in Fig. 2;
- Fig. 9: eine schematische Schnittansicht entlang einer Schnittachse A des Schaltschranksystems in Fig. 2 gemäß einer weiteren Ausführungsform;
- Fig. 10: eine weitere schematische Innenansicht des Funktionsmoduls in Fig. 5;
- Fig. 11: eine perspektivische schematische Ansicht eines Heizelements gemäß einer Ausführungsform;
- Fig. 12: eine perspektivische schematische Ansicht des Heizelements in Fig. 11, wobei das Heizelement in ein Basismodul integriert ist;
- Fig. 13: eine perspektivische schematische Ansicht des Heizelements in Fig. 11, wobei das Heizelement in ein Basismodul integriert ist;
- Fig. 14: eine weitere perspektivische schematische Ansicht eines Schaltschranksystems gemäß einer weiteren Ausführungsform;
- Fig. 15: eine weitere perspektivische schematische Ansicht eines Schaltschranksystems gemäß einer weiteren Ausführungsform; und
- Fig. 16: eine weitere perspektivische schematische Ansicht eines Schaltschranksystems gemäß einer weiteren Ausführungsform.

Die Erfindung ist im Folgenden anhand von Ausführungsbeispielen von Varianten eines modularen Schaltschranksystems näher erläutert. Obwohl die Erfindung detaillierter durch die Ausführungsbeispiele näher beschrieben und illustriert ist, so ist die Erfindung nicht durch die offenbarten Ausführungsbeispiele eingeschränkt, sondern ist von grundlegenderer Natur.

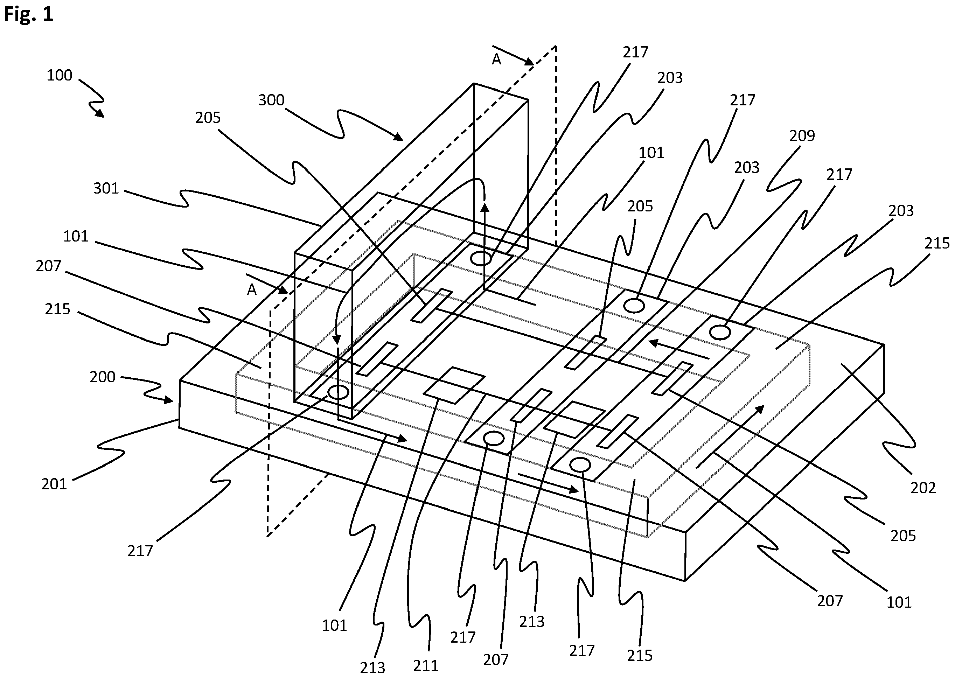

Fig. 1 zeigt eine perspektivische schematische Ansicht eines Schaltschranksystems 100 gemäß einer Ausführungsform.

In der Ausführungsform in Fig. 1 umfasst das Schaltschranksystem 100 ein Basismodul 200 und ein Funktionsmodul 300. Das Funktionsmodul 300 ist über entsprechende Anschlüsse an das Basismodul 200 angeschlossen.

Das Basismodul 200 umfasst ein Basisgehäuse 201 mit einer ersten Gehäuseseite 202. An der ersten Gehäuseseite 202 ist eine Mehrzahl von Basisanschlusselementen 203 angeordnet. Jedes Basisanschlusselement 203 umfasst Basisspannungsanschlüsse 205 und Basisdatenanschlüsse 207. Die Basisspannungsanschlüsse 205 sind über eine Spannungsleitung 209 verbunden. Die Basisdatenanschlüsse 207 sind über eine Datenleitung 211 verbunden. Das Basismodul 200 umfasst ferner eine Mehrzahl von Anschalteinheiten 213, die über die Datenleitung 211 mit den Basisdatenanschlüssen 207 verbunden sind. Die Basisspannungsanschlüsse 205 und die Spannungsleitung 209 können eine Kleinspannung und/oder eine Niederspannung bereitstellen. Die Anschalteinheiten 213 können als ASICs ausgebildet sein und die Datenleitung 211 kann als Datenbus ausgebildet sein und eine Datenkommunikation zwischen dem Basismodul 200 und den Funktionsmodulen 300 bereitstellen.

Das Basismodul 200 weist ferner einen Zirkulationskanal 215 auf, der im Inneren des Basisgehäuses 201 ausgebildet ist. Innerhalb des Zirkulationskanals 215 ist eine Zirkulation eines Luftstroms ermöglicht. Jedes Basisanschlusselement 203 weist ferner Zirkulationsöffnungen 217 auf, die in fluidtechnischer Verbindung mit dem Zirkulationskanal 215 stehen.

Das Funktionsmodul 300 weist ein Funktionsgehäuse 301 auf und ist am Basismodul 200 angeschlossen. An einer Unterseite des Funktionsgehäuses 301 weist das Funktionsmodul 300 ein Funktionsanschlusselement mit Spannungsanschlüssen und Datenanschlüssen auf. Das Funktionsanschlusselement ist in Fig. 1 nicht dargestellt. Die Datenanschlüsse und Spannungsanschlüsse des Funktionsanschlusselements des Funktionsmoduls 300 sind mit den Basisdatenanschlüssen 207 und den Basisspannungsanschlüssen 205 des Basisanschlusselements 203 des Basismoduls 200 verbindbar, wodurch eine datentechnische und spannungstechnische Verbindung zwischen dem Basismodul 200 und dem Funktionsmodul 300 hergestellt ist. Ferner umfasst das Funktionsanschlusselement des Funktionsmoduls 300 Kopplungsöffnungen, die mit den Zirkulationsöffnungen 217 der Basisanschlusselemente 203 des Basismoduls 200 koppelbar sind. Durch eine Verbindung des Funktionsmoduls 300 mit dem Basismodul 200 über eine Kopplung des Funktionsanschlusselements des Funktionsmoduls 300 mit einem der Basisanschlusselemente 203 des Basismoduls 200 ist eine Kopplung der Zirkulationsöffnungen 217 eines der Basisanschlusselemente 203 des Basismoduls 200 und den Kopplungsöffnungen des Funktionsanschlusselements des Funktionsmoduls 300 erreicht. Hierüber ist eine fluidtechnische Verbindung zwischen einem Inneren des Funktionsgehäuses 301 des Funktionsmoduls 300 und dem Zirkulationskanal 215 des Basismoduls 200 erreicht. In Fig. 1 ist eine solche Verbindung zwischen dem Funktionsmodul 300 und dem Basismodul 200 dargestellt, bei der eine fluidtechnische Verbindung zwischen dem Inneren des Funktionsgehäuses 301 und dem Zirkulationskanal 215 des Basismoduls 200 hergestellt ist.

Über die fluidtechnische Verbindung zwischen dem Inneren des Funktionsgehäuses 301 des Funktionsmoduls 300 und dem Zirkulationskanal 215 des Basismoduls 200 ist ein Zirkulationskreislauf 101 hergestellt, der den Zirkulationskanal 215 des Basismoduls 200 und das Innere des Funktionsgehäuses 301 des mit dem Basismodul 200 verbundenen Funktionsmoduls 300 umfasst. Innerhalb des Zirkulationskreislaufs 101 ist eine Zirkulation eines Luftstroms ermöglicht, die in Fig. 1 durch die Pfeile dargestellt ist. Die Zirkulation des Luftstroms verläuft innerhalb des Zirkulationskanals 215 in einer vorbestimmten Zirkulationsrichtung und strömt über eine der Kopplungsöffnungen in das Innere des Funktionsgehäuses 301 ein, aus dem der zirkulierende Luftstrom aus einer weiteren Kopplungsöffnung ausströmt und in den Zirkulationskanal 215 des Basismoduls 200 wieder eintritt.

Die Zirkulation des Luftstroms innerhalb des Zirkulationskreislaufs 101 kann beispielsweise durch Konvektion erzielt werden, indem aufgrund unterschiedlicher Temperaturen innerhalb des Funktionsgehäuses 301 des Funktionsmoduls 300 beziehungsweise des Zirkulationskanals 215 des Basismoduls 200 eine Druckdifferenz entsteht, die zu einer Zirkulation innerhalb des Luftvolumens des Zirkulationskreislaufs 101 und einer damit verbundenen Bildung eines zirkulierenden Luftstroms führt.

Das Funktionsmodul 300 umfasst ferner eine elektronische Funktionsschaltung, die im Funktionsgehäuse 301 angeordnet ist. Die Funktionsschaltung ist in Fig. 1 nicht dargestellt. Über den im Zirkulationskreislauf 101 zirkulierenden Luftstrom kann eine Durchmischung des im Inneren des Funktionsgehäuses 301 des Funktionsmoduls 300 befindlichen Luftvolumens erreicht werden, wodurch eine Bildung von Wärmestaunestern innerhalb des Funktionsgehäuses 301 vermieden wird.

Wärmestaunester beschreiben hierbei Bereiche des Luftvolumens innerhalb eines Funktionsgehäuses 301, die aufgrund einer lokalen Erwärmung durch Komponenten der elektronischen Funktionsschaltung des jeweiligen Funktionsmoduls 300 eine erhöhte Temperatur aufweisen. Durch die Durmischung des Luftvolumens innerhalb des Funktionsgehäuses 301 können diese Bereiche zerstreut werden, sodass eine gleichmäßige Temperaturverteilung innerhalb des Luftvolumens innerhalb des Funktionsgehäuses 301 und eine damit verbundene Kühlleistung erreicht wird.

Die in Fig. 1 gezeigte Darstellung des Schaltschranksystems 100 ist lediglich beispielhafter Natur und stellt keine detailgetreue sowie auch keine größengetreue Abbildung eines Schaltschranksystems 100 gemäß der vorliegenden Erfindung dar. Insbesondere kann abweichend zu der in Fig. 1 dargestellten Ausführungsform eine Vielzahl von Basisanschlusselementen 203 an dem Basismodul 200 ausgebildet sein. Darüber hinaus kann eine Vielzahl von Funktionsmodulen 300 an dem Basismodul 200 angeschlossen sein. Ferner kann der Zirkulationskanal 215 eine von der in Fig. 1 gezeigten Form abweichende Ausgestaltung aufweisen. Beispielsweise kann der Zirkulationskanal 215 eine kreisrunde beziehungsweise elliptische Form aufweisen. Darüber hinaus können die Anordnungen der Basisspannungsanschlüsse 205 beziehungsweise Basisdatenanschlüsse 207 wie auch der Zirkulationsöffnungen 217 auf den jeweiligen Basisanschlusselementen 203 von der in Fig. 1 gezeigten Darstellung abweichen.

Ferner zeigt die Fig. 1 eine Schnittebene A auf, die zur Beschreibung weiterer Figuren dient.

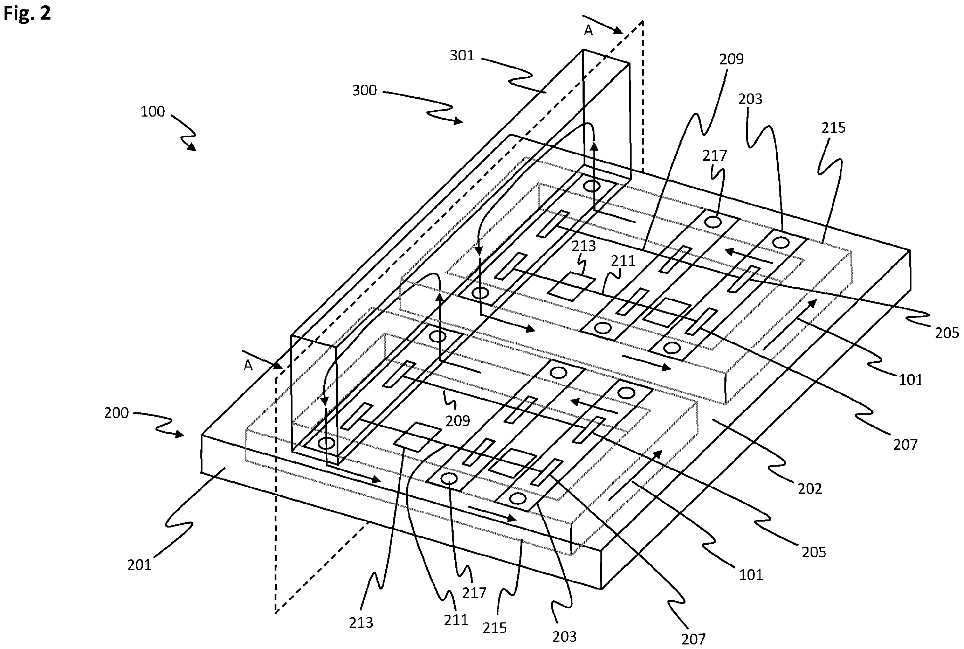

Fig. 2 zeigt eine weitere perspektivische schematische Ansicht des Schaltschranksystems 100 gemäß einer weiteren Ausführungsform.

In Fig. 2 umfasst das Basismodul 200 zwei Zirkulationskanäle 215 auf, die im Basisgehäuse 201 nebeneinander angeordnet sind. In jedem Zirkulationskanal 215 kann gemäß einem durch den Zirkulationskanal 215 definierten Zirkulationskreislauf 101 ein Luftstrom zirkulieren.

Jeder Zirkulationskanal 215 ist analog zu dem in Fig. 1 ausgebildet. Ferner weist das Basismodul 200 im Vergleich zur Ausführungsform in Fig. 1 zwei Sätze von Basisanschlusselementen 203 mit Basisdatenanschlüssen 207 und Basisspannungsanschlüssen 205, Datenleitungen 211, Spannungsleitungen 209, Anschalteinheiten 213 auf, die jeweils analog zur Ausführungsform in Fig. 1 ausgebildet sind. Jedes Basisanschlusselement 203 weist ferner Zirkulationsöffnungen 217 auf, die in fluidtechnischer Verbindung mit dem Zirkulationskanal 215 stehen.

In Fig. 2 weist das Schaltschranksystem 100 in Fig. 2 ein Funktionsmodul 300 gemäß einer weiteren Ausführungsform auf. In der Ausführungsform in Fig. 2 ist das Funktionsmodul 300 eingerichtet, über die zwei Sätze von Basisanschlusselementen 203 mit dem Basismodul 200 zu koppeln. Somit ist das Funktionsmodul 300 eingerichtet, in fluidische Verbindung mit den zwei nebeneinander angeordneten Zirkulationskanälen 215 zu treten.

Wie in Fig. 2 gezeigt, kann somit über die zwei Zirkulationskreisläufe 101 jeweils ein zirkulierender Luftstrom in das Funktionsgehäuse 301 eindringen und für eine Durchmischung des Luftvolumens im Funktionsgehäuses 301 sorgen.

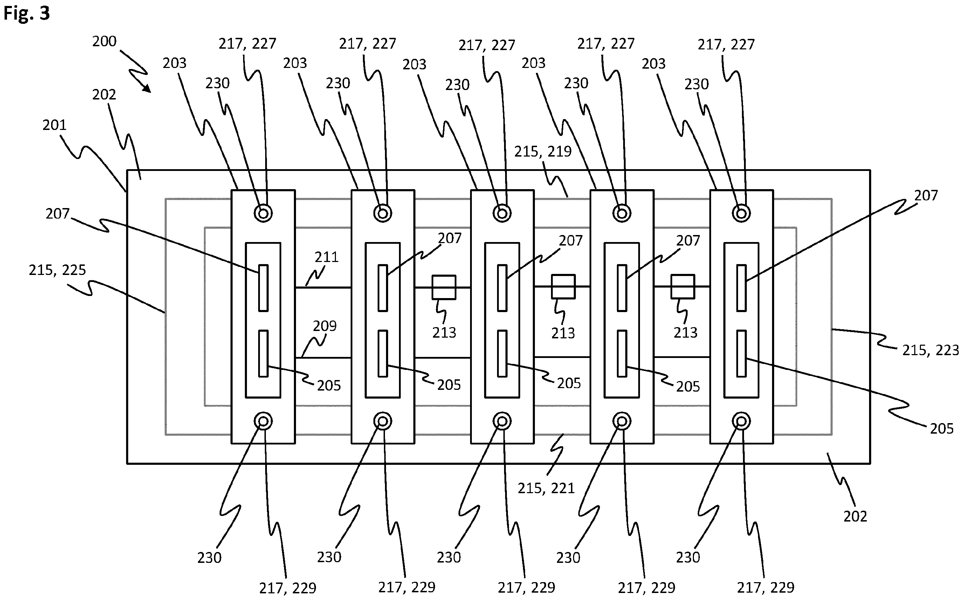

Fig. 3 zeigt eine schematische Draufsicht eines Basismoduls 200 gemäß einer Ausführungsform.

In Fig. 3 ist das Basismodul 200 des Schaltschranksystems 100 gemäß einer weiteren Ausführungsform dargestellt. Abweichend zu der Ausführungsform in Fig. 1 umfasst der Zirkulationskanal 215 einen ersten Teilkanal 219, einen zweiten Teilkanal 221, einen dritten Teilkanal 223 und einen vierten Teilkanal 225. Der erste Teilkanal 219 ist parallel zum zweiten Teilkanal 221 ausgebildet und der dritte Teilkanal 223 ist parallel zum vierten Teilkanal 225 ausgebildet.

Ferner weist jedes Basisanschlusselement 203 eine erste Zirkulationsöffnung 227, die mit dem ersten Teilkanal 219 in fluidtechnischer Verbindung steht, und eine zweite Zirkulationsöffnung 229 auf, die mit dem zweiten Teilkanal 221 in fluidtechnischer Verbindung steht. Darüber hinaus ist jede Zirkulationsöffnung 217 mit einem Regulierungsmittel 230 versehen, das eingerichtet ist, einen Luftstrom durch die jeweilige Zirkulationsöffnung 217 zu regulieren. Die Regulierungsmittel 230 können beispielsweise als entsprechende Düsenelemente ausgebildet sein.

Alternativ können die Regulierungsmittel 230 derart ausgebildet sein, dass ein Durchmesser der jeweiligen Zirkulationsöffnung 217 modifiziert ist. Die Regulierungsmittel 230 ermöglichen, dass durch jede Zirkulationsöffnung 217 ein identischer Luftstrom strömt. Hierdurch kann erreicht werden, dass bei einer Anordnung einer Mehrzahl von Funktionsmodulen 300 am Basismodul 200, die der Reihe nach an den jeweiligen Basisanschlusselementen 203 angeschlossen werden, durch die jeweiligen Zirkulationsöffnungen 217 ein Luftstrom des Zirkulationskreislaufs 101 von identischer Stärke in das jeweilige Funktionsgehäuse 301 einströmt. Des Weiteren können die Regulierungsmittel 230 druckausgleichend wirken und dazu ausgebildet sein auch bei unterschiedlichen Druckdifferenzen einen immer gleich großen Volumenaustausch bzw. Volumenstrom der zirkulierenden Luft zu gewährleisten.

Hierdurch wird wiederum erreicht, dass unabhängig von der Positionierung des jeweiligen Funktionsmoduls 300 am Basismodul 200 und unabhängig von der Anzahl von am Basismodul 200 positionierten Funktionsmodulen 300 jedes Funktionsmodul 300 mit einem identisch starken Luftstrom und damit verbunden mit einer identischen Kühlleistung versorgt wird.

Alternativ kann über die Regulierungsmittel 230 ein Luftstrom für bestimmte Funktionsmodule 300 individuell angepasst werden, sodass für Funktionsmodule 300 mit einer starken Wärmeentwicklung ein entsprechend starker Luftstrom und für Funktionsmodule 300 mit einer vergleichsweise geringen Wärmeentwicklung ein vergleichsweise schwacher Luftstrom bereitgestellt wird.

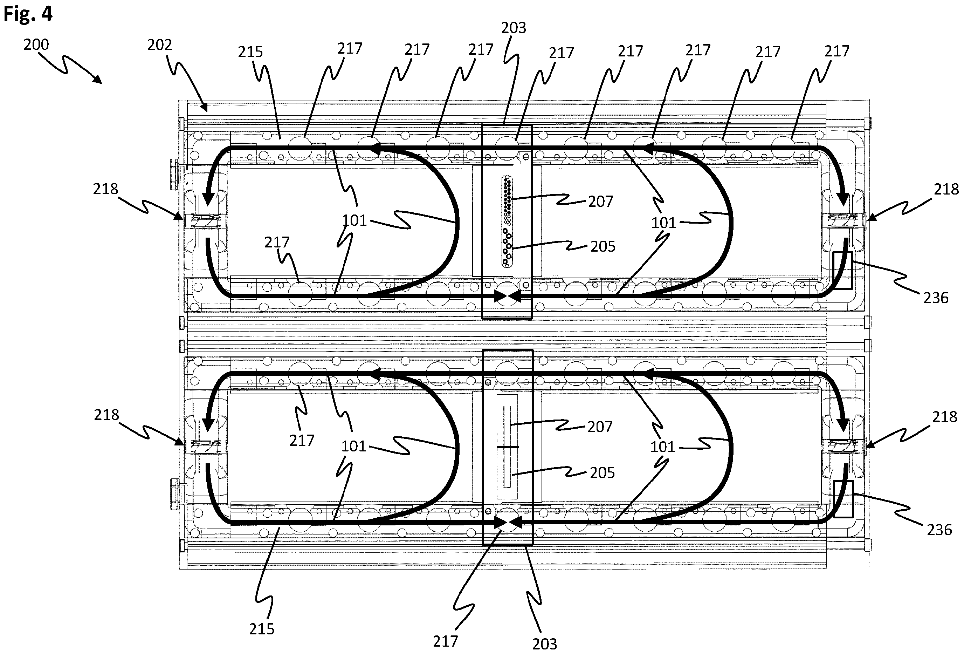

Fig. 4 zeigt eine weitere schematische Draufsicht eines Basismoduls 200 gemäß einer weiteren Ausführungsform.

Abweichend zu der Ausführungsform in Fig. 3 weist das Basismodul 200 in Fig. 4 zwei Zirkulationskanäle 215 auf, die nebeneinander angeordnet sind. Darüber hinaus weist das Basismodul 200 zwei parallel angeordnete Reihen von Basisanschlusselementen 203 auf, die jeweils Basisspannungsanschlüsse 205, Basisdatenanschlüsse 207 und Zirkulationsöffnungen 217 aufweisen.

Alternative zu der hier gezeigten Ausführungsform können die Basisanschlusselemente 203 auch anders ausgebildet sein. Beispielsweise können die Basisanschlusselemente 203 jeweils eine Reihe mit Daten- und Kleinspannungsanschlüssen und eine Reihe mit Niederspannungsanschlüssen aufweisen. Alternativ können die Basisanschlusselemente 203 zwei Reihen mit Daten- und Kleinspannungsanschlüssen aufweisen. Alternativ können die Basisanschlusselemente 203 eine Reihe mit Daten- und Kleinspannungsanschlüssen und eine Reihe mit Daten- und Kleinspannungsanschlüssen und Niederspannungsanschlüssen aufweisen.

In jedem Zirkulationskanal 215 ist ein zirkulierender Luftstrom gemäß dem Zirkulationskreislauf 101 dargestellt. Abweichend zu der Ausführungsform in Fig. 1 beziehungsweise Fig. 3 weist das Basismodul 200 in Fig. 4 ferner vier Ventilatorelemente 218 auf, die jeweils paarweise in den zwei Zirkulationskanälen 215 angeordnet sind. Die Ventilatorelemente 218 sind ausgebildet, das Luftvolumen innerhalb des Zirkulationskanals 215 beziehungsweise innerhalb des Zirkulationskreislaufs 101 zu beschleunigen und somit einen zirkulierenden Luftstrom zu erzeugen beziehungsweise anzutreiben.

Alternativ zu der in Fig. 4 gezeigten Ausführungsform kann jeder Zirkulationskanal 215 auch lediglich mit einem Ventilatorelement 218 ausgebildet sein. Alternativ können die Ventilatorelemente 218 auch innerhalb eines Funktionsgehäuses 301 eines Funktionsmoduls 300 angeordnet sein, sodass bei Anschluss des jeweiligen Funktionsmoduls 300 an das Basismodul 200 durch den Betrieb des im jeweiligen Funktionsgehäuse 301 angeordneten Ventilatorelements 218 eine Zirkulation des Luftvolumens innerhalb des Zirkulationskreislaufs 101 bewirkt werden kann.

Alternativ kann das Schaltschranksystem 100 auch ein Funktionsmodul 300 umfassen, das als Kühlungsmodul ausgebildet ist. Ein als Kühlungsmodul ausgebildetes Funktionsmodul 300 umfasst kein Funktionsschaltung kann jedoch mit wenigstens einem Ventilatorelement 218 ausgebildet sein, das innerhalb des jeweiligen Funktionsgehäuses 301 des als Kühlungsmodul ausgestalteten Funktionsmoduls 300 angeordnet ist.

Eine Zirkulationsrichtung des zirkulierenden Luftstroms ist in Fig. 4 durch die Pfeile dargestellt. Alternativ zu der in Fig. 4 dargestellten Zirkulationsrichtung kann eine beliebige Zirkulation des Luftvolumens innerhalb des Zirkulationskreislaufs 101 beziehungsweise innerhalb des Zirkulationskanals 215 durch einen entsprechenden Betrieb der Ventilatorelemente 218 erreicht werden.

Zusätzlich umfasst das Basismodul 200 in der Ausführungsform in Fig. 4 zwei Wärmetauscher 236, die jeweils in einem Zirkulationskanal 215 ausgebildet sind. Über die Wärmetauscher 236 kann das im Zirkulationskreislauf 101 beziehungsweise im Zirkulationskanal 215 zirkulierende Luftvolumen gekühlt werden, indem dieses beim Vorbeiströmen am jeweiligen Wärmetauscher 236 eine im Luftvolumen gespeicherte Wärmemenge an den jeweiligen Wärmetauscher 236 abgibt. Alternativ zu der in Fig. 4 dargestellten Ausführungsform kann eine beliebige Anzahl von Wärmetauschern innerhalb der Zirkulationskanäle 215 des Basismoduls 200 angeordnet werden. Alternativ können Wärmetauscher 236 in einem oder mehreren Funktionsgehäusen 301 eines oder mehrerer Funktionsmodule 300 angeordnet werden, sodass ein Kühleffekt des im jeweiligen Funktionsgehäuse 301 befindlichen Luftvolumens bei einem Vorbeiströmen an den jeweiligen Wärmetauscher 236 erreicht werden kann.

Alternativ kann auch wenigstens ein Wärmetauscher 236 innerhalb eines Funktionsgehäuses 301 eines als Kühlungsmodul ausgestalteten Funktionsmoduls 300 angeordnet sein.

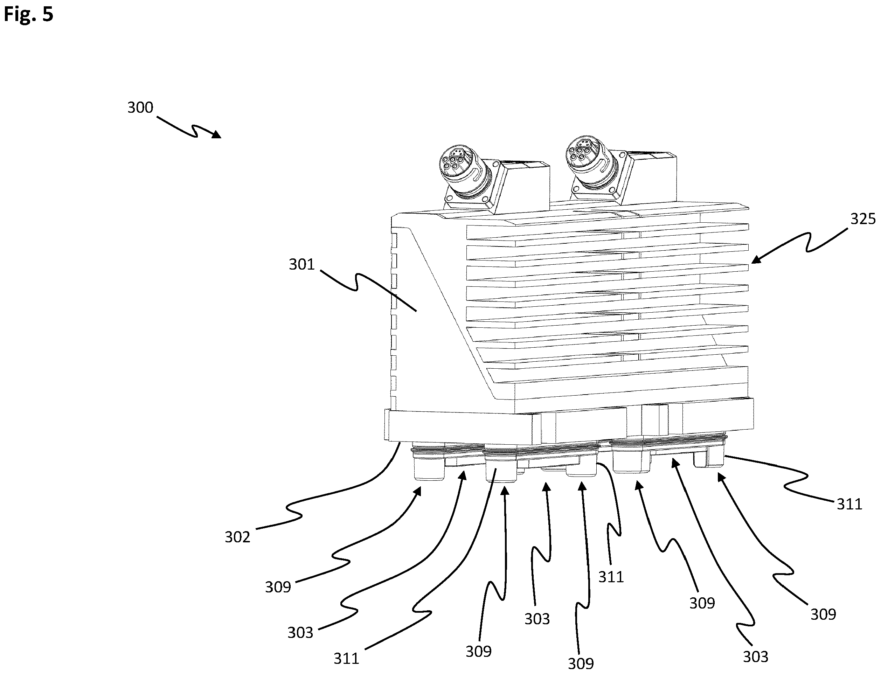

Fig. 5 zeigt eine perspektivische schematische Ansicht eines Funktionsmoduls 300 gemäß einer Ausführungsform.

In der Ausführungsform in Fig. 5 weist das Funktionsmodul 300 an einer Seite des Funktionsgehäuses 301 weitere Kühlrippen 325 auf, die einen Kühleffekt des im Inneren des Funktionsgehäuses 301 befindlichen Luftvolumens ermöglichen. Über die weiteren Kühlrippen 325 wird eine Abstrahlung einer Wärmemenge an eine Umgebung des Funktionsmoduls 300 durch eine Erhöhung der Oberfläche der jeweiligen Seite des Funktionsgehäuses 301 erhöht.

Ferner weist in der Ausführungsform in Fig. 5 das Funktionsmodul 300 an einer Gehäuseunterseite 302 des Funktionsgehäuses 301 eine Mehrzahl von Funktionsanschlusselementen 303 auf. Jedes Funktionsanschlusselement 303 weist zwei Kopplungsöffnungen 309 auf. Jede Kopplungsöffnung 309 weist einen umgebenden Kopplungskragen 311 auf, der vom Funktionsanschlusselement 303 hervorsteht.

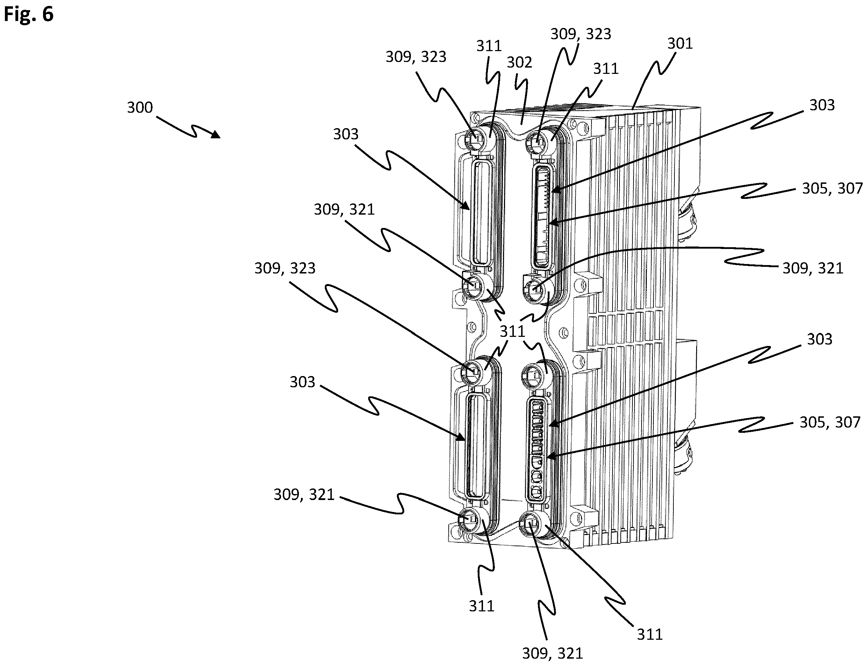

Fig. 6 zeigt eine schematische Bodenansicht des Funktionsmoduls 300 in Fig. 5.

In Fig. 6 ist die Anordnung der einzelnen Funktionsanschlusselemente 303 an der Gehäuseunterseite 302 des Funktionsgehäuses 301 des Funktionsmoduls 300 in Fig. 5 dargestellt. An der Gehäuseunterseite 302 sind vier Funktionsanschlusselemente 303 angeordnet, die in zwei senkrecht orientierte Richtungen jeweils paarweise hintereinander angeordnet sind. Die Funktionsanschlusselemente 303 sind hierbei stabförmig ausgebildet und entsprechen der Struktur der in den Figuren 1 bis 4 gezeigten Basisanschlusselemente 203 des Basismoduls 200. Jedes Funktionsanschlusselement 303 kann Spannungsanschlüsse 305 und Datenanschlüsse 307 umfassen, die jeweils nebeneinander am Funktionsanschlusselement 303 angeordnet sind. Alternativ kann die Belegung der Funktionsanschlusselemente 303 eines Funktionsmoduls 300 unterschiedlich ausgestalte sein. Beispielsweise können einzelne Funktionsanschlusselemente 303 ohne Belegung bleiben und somit keine Datenanschlüsse 307 oder Spannungsanschlüsse 305 umfassen. Andere Funktionsanschlusselemente 303 können jeweils nur Datenschlüsse 307 oder ausschließlich Spannungsanschlüsse 305 aufweisen. Die Anordnung der Anschlüsse in der Ausführungsform in Fig. 6 ist lediglich beispielhaft.

Darüber hinaus umfasst jedes Funktionsanschlusselement 303 zwei Kopplungsöffnungen 309, die jeweils an gegenüberliegenden Enden der Funktionsanschlusselemente 303 angeordnet sind. Jede Kopplungsöffnung 309 weist einen Kopplungskragen 311 auf, der die Kopplungsöffnung 309 umgibt und vom Funktionsanschlusselement 303 hervorsteht. Die zwei Kopplungsöffnungen 309 eines jeden Funktionsanschlusselements 303 sind jeweils in eine erste Kopplungsöffnung 321 und eine zweite Kopplungsöffnung 323 aufgeteilt. Entsprechend der Ausführungsform in Fig. 3 des Basismoduls 200 ist die erste Kopplungsöffnung 321 mit der ersten Zirkulationsöffnung 227 koppelbar und die zweite Kopplungsöffnung 323 ist mit der zweiten Zirkulationsöffnung 229 koppelbar.

Abweichend von der in Fig. 6 dargestellten Ausführungsform kann ein Funktionsmodul 300 eine beliebige Anzahl von Funktionsanschlusselementen 303 aufweisen. Darüber hinaus kann die Anordnung der Kopplungsöffnungen 309 an einem Funktionsanschlusselement 303 von der in Fig. 6 dargestellten Anordnung abweichen.

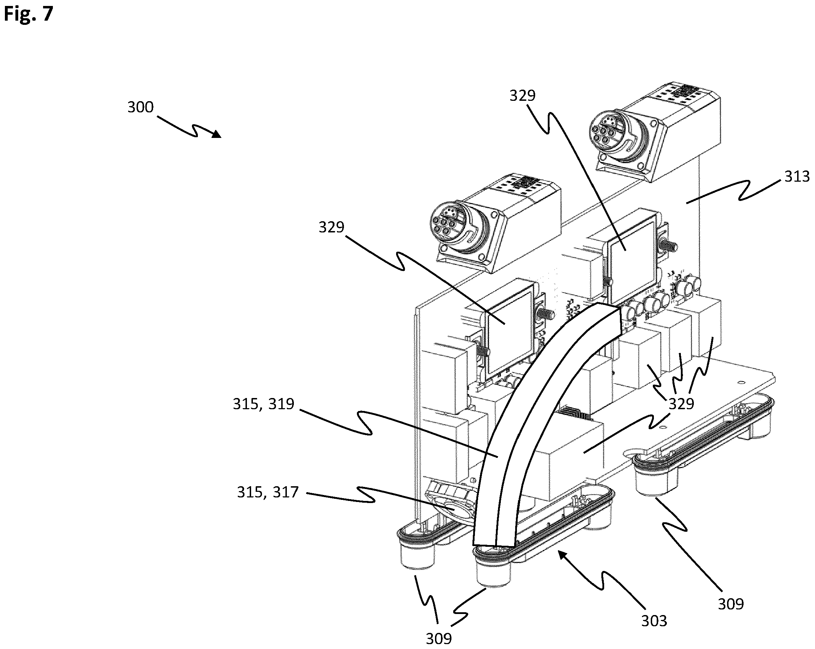

Fig. 7 zeigt eine schematische Innenansicht des Funktionsmoduls 300 in Fig. 5.

In Fig. 7 ist das Innere des Funktionsmoduls 300 aus Fig. 5 beziehungsweise Fig. 6 dargestellt. Die im Inneren des Funktionsgehäuses 301 angeordnete elektronische Funktionsschaltung 313 umfasst eine Mehrzahl von Komponenten 329 der elektronischen Funktionsschaltung 313. Die in Fig. 7 dargestellten Komponenten 329 beziehungsweise die dargestellte elektronische Funktionsschaltung 313 ist lediglich beispielhafter Natur und kann von Funktionsmodul zu Funktionsmodul 300 je nach Funktionalität des jeweiligen Funktionsmoduls 300 verschieden sein.

In der Ausführungsform in Fig. 7 umfasst das Funktionsmodul 300 ferner Führungsmittel 315, die eingerichtet sind, einen Luftstrom, der durch wenigstens eine der Kopplungsöffnungen 309 in das Innere des Funktionsgehäuses 301 einströmt, in einen vorbestimmten Bereich innerhalb des Funktionsgehäuses 301 zu leiten. In der Ausführungsform in Fig. 7 sind die Führungsmittel 315 zum einen als ein Führungsventilatorelement 317 ausgebildet, das einen Luftstrom beliebig durch das Innere des Funktionsgehäuses 301 führen kann. Der vorbestimmte Bereich innerhalb des Funktionsgehäuses 301 kann beispielsweise der Bereich einer bestimmten Komponente 329 der elektronischen Funktionsschaltung 313 sein, die eine besondere Wärmeentwicklung aufweist.

Alternativ kann der Bereich das gesamte Innere des Funktionsgehäuses 301 beziehungsweise einen Großteil der elektronischen Funktionsschaltung 313 umfassen, sodass ein durch das Führungsmittel 315 beziehungsweise das Führungsventilatorelement 317 geführter Luftstrom einen Großteil der Funktionsschaltung 313 umströmt. In der Ausführungsform in Fig. 7 ist ein Führungsmittel 315 ferner als ein Führungskanal 319 ausgebildet, der von einer Kopplungsöffnung 309 in das Innere des Funktionsgehäuses 301 reicht und ausgebildet ist, den aus der Kopplungsöffnung 309 in das Funktionsgehäuse 301 strömenden Luftstrom in einen vorbestimmten Bereich innerhalb des Funktionsgehäuses 301 zu führen.

Alternativ zu der in Fig. 7 gezeigten Ausführungsform können beliebige Führungsventilatorelemente 317 innerhalb des Funktionsgehäuses 301 an verschiedenen Stellen angeordnet sein. Darüber hinaus kann eine Vielzahl verschieden geformter Führungskanäle 319 innerhalb des Funktionsgehäuses 301 angeordnet sein.

Alternativ können Führungsmittel 315 als Führungsdüsen 316 ausgebildet sein, die an den jeweiligen Kopplungsöffnungen 309 angeordnet sind.

Die Führungsventilatorelemente 317 und/oder die Führungskanäle 319 und/oder die Führungsdüsen 316 können aus Kunststoff, Metall oder einem geeigneten Verbundwerkstoff gefertigt sein.

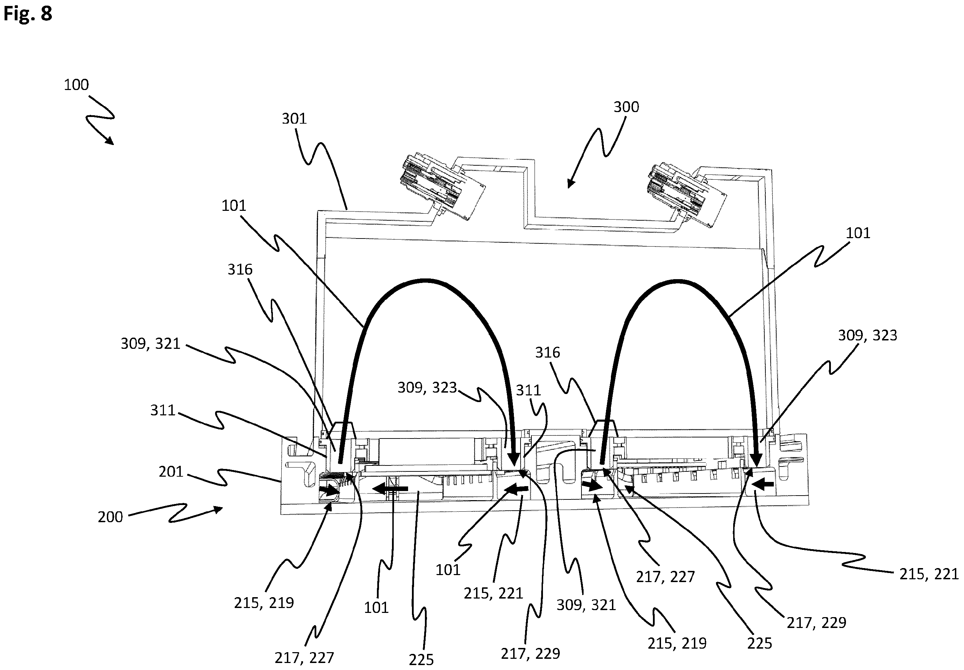

Fig. 8 zeigt eine schematische Schnittansicht entlang einer Schnittachse A des Schaltschranksystems 200 in Fig. 2.

In Fig. 8 ist ein Verlauf eines durch den Zirkulationskreislauf 101 strömenden Luftstroms durch das Innere des Basisgehäuses 201 des Basismoduls 200 beziehungsweise durch das Innere des Funktionsgehäuses 301 des Funktionsmoduls 300 eines Schaltschranksystems 100 mit einem Basismodul 200 gemäß der Ausführungsform in Fig. 4 und einem Funktionsmodul 300 gemäß der Ausführungsformen in Figuren 5 bis 7 gezeigt.

Die Schnittdarstellung entspricht der in Fig. 2 gezeigten Schnittebene A.

In Fig. 8 umfasst das Basismodul 200 analog zu der Ausführungsform in Fig. 4 zwei Zirkulationskanäle 215, die nebeneinander angeordnet sind. Jeder der zwei Zirkulationskanäle 215 umfasst einen ersten Teilkanal 219, einen parallel dazu angeordneten zweiten Teilkanal 221 und einen dritten Teilkanal 223 sowie einen parallel dazu angeordneten vierten Teilkanal 225. In Fig. 8 ist aufgrund der Schnittdarstellung der dritte Teilkanal 223 nicht dargestellt.

Ferner umfasst das Basismodul 200 eine Mehrzahl von Basisanschlusselementen 203, die in Fig. 8 aufgrund der Schnittdarstellung nicht gezeigt sind. Jedes der Basisanschlusselemente 203 umfasst eine erste Zirkulationsöffnung 227 und eine zweite Zirkulationsöffnung 229. Die erste Zirkulationsöffnung 227 ist fluidtechnisch mit dem ersten Teilkanal 219 verbunden. Die zweite Zirkulationsöffnung 229 ist fluidtechnisch mit dem zweiten Teilkanal 221 verbunden.

Analog zu den Ausführungsformen in Figuren 5 bis 7 umfasst das gezeigte Funktionsmodul 300 vier Funktionsanschlusselemente 303, die in Fig. 8 aufgrund der Schnittdarstellung nicht gezeigt sind. Jedes der Funktionsanschlusselemente 303 umfasst eine erste Kopplungsöffnung 321 und eine zweite Kopplungsöffnung 323. Jede Kopplungsöffnung 309 umfasst einen Kopplungskragen 311, der von dem Funktionsanschlusselement 303 hervorsteht. In Fig. 8 sind die Kopplungskragen 311 der jeweiligen Kopplungsöffnungen 309 in die entsprechenden Zirkulationsöffnungen 217 des Basismoduls 200 eingeführt. In Fig. 8 sind somit die ersten Kopplungsöffnungen 321 mit den ersten Zirkulationsöffnungen 227 verbunden und die zweiten Kopplungsöffnungen 323 sind mit den zweiten Zirkulationsöffnungen 229 verbunden.

Darüber hinaus sind an den ersten Kopplungsöffnungen 321 Führungsdüsen 316 ausgebildet, die den durch die ersten Kopplungsöffnungen 321 in das Innere des Funktionsgehäuses 301 einströmenden Luftstrom in einen vorbestimmten Bereich innerhalb des Funktionsgehäuses 301 führen.

Hierdurch ist eine fluidtechnische Verbindung zwischen dem Zirkulationskanal 215 und dem Inneren des Funktionsgehäuses 301 des Funktionsmoduls 300 hergestellt.

In der Ausführungsform in Fig. 8 verläuft eine Zirkulation eines Luftstroms entlang des Zirkulationskreislaufs 101 derart, dass innerhalb des zweiten Teilkanals 221 des Zirkulationskanals 215 die Strömungsrichtung des Luftstroms in die Blattebene der Fig. 8 hineinzeigt, was durch den im zweiten Teilkanal 221 dargestellten Pfeil illustriert ist. Im vierten Teilkanal 225 verläuft die Strömungsrichtung entsprechend dem dargestellten Pfeil von rechts nach links. Im ersten Teilkanal 219 verläuft die Strömungsrichtung aus der Blattebene der Fig. 8 herausgerichtet. Aus dem ersten Teilkanal 219 verläuft der zirkulierende Luftstrom durch die erste Zirkulationsöffnung 227 beziehungsweise die mit dieser gekoppelten ersten Kopplungsöffnung 321 in das Innere des Funktionsgehäuses 301 des Funktionsmoduls 300. Innerhalb des Funktionsmoduls 300 verläuft der zirkulierende Luftstrom entlang der im Funktionsgehäuse 301 angeordneten elektronischen Funktionsschaltung 313 und verlässt das Funktionsgehäuse 301 durch die zweite Kopplungsöffnung 323 und tritt durch die mit dieser gekoppelten zweiten Zirkulationsöffnung 229 in den zweiten Teilkanal 221 ein. Hierdurch ist ein zirkulierender Luftstrom erreicht, der durch den Zirkulationskanal 215 des Basismoduls 200 und durch das Innere des Funktionsgehäuses 301 des Funktionsmoduls 300 verläuft.

Der Verlauf des zirkulierenden Luftstroms innerhalb des Funktionsgehäuses 301 ist in Fig. 8 lediglich beispielhaft dargestellt. Alternativ zum dem in Fig. 8 dargestellten Verlauf kann der Verlauf innerhalb des Funktionsgehäuses 301 durch beliebige Gegenstände innerhalb des Funktionsgehäuses 301, beispielsweise Komponenten 329 der elektronischen Funktionsschaltung 313 beziehungsweise durch weitere Führungsmittel 315 abweichend verlaufen. Insbesondere ist auch ein Luftstrom möglich, der zwischen den zwei Zirkulationskanälen ausgetauscht wird und beispielsweise über die erste Kopplungsöffnung 321 des einen Zirkulationskanals in das Funktionsgehäuse 301 eintritt und über die zweite Kopplungsöffnung 323 des jeweils anderen Zirkulationskanals aus dem Funktionsgehäuse 301 wieder austritt.

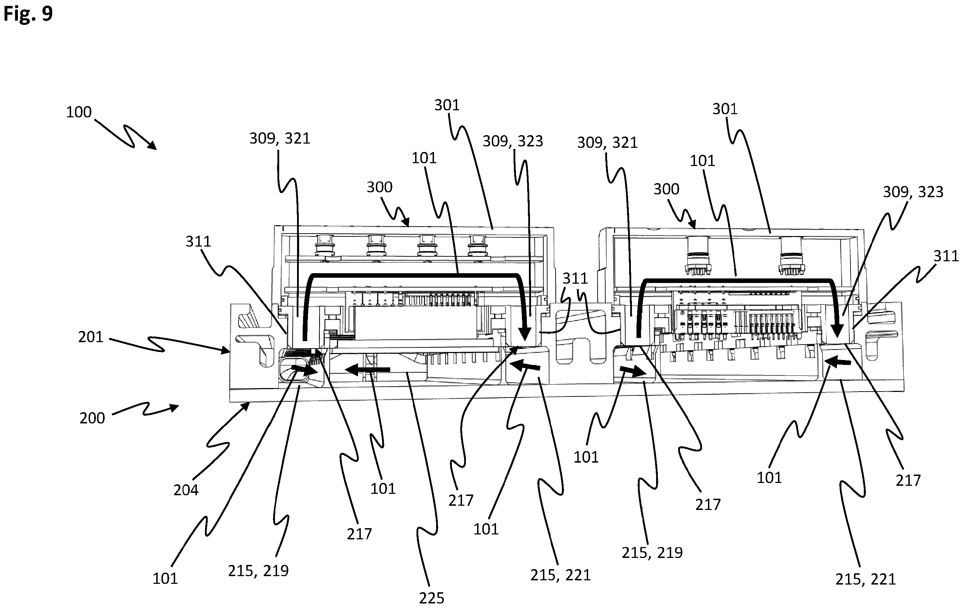

Fig. 9 zeigt eine schematische Schnittansicht entlang der Schnittachse A des Schaltschranksystems 200 in Fig. 2 gemäß einer weiteren Ausführungsform.

Abweichend zu der in Fig. 2 gezeigten Ausführungsform sind in Fig. 9 zwei kleine Funktionsmodule 300, die gemäß Fig. 1, jeweils lediglich mit einem der beiden nebeneinander angeordneten Zirkulationskanäle 215 verbunden ist.

In Fig. 9 ist der Verlauf eines zirkulierenden Luftstroms innerhalb des Zirkulationskreislaufs 101 für zwei Funktionsmodule 300 gezeigt. Die in Fig. 9 dargestellten Funktionsmodule 300 weichen von den in den Figuren 5 bis 8 dargestellten Funktionsmodulen dahingehend ab, dass diese lediglich maximal zwei nebeneinander angeordnete Funktionsanschlusselemente 303 aufweisen. In Fig. 9 ist somit jedes Funktionsmodul 300 lediglich an einen Zirkulationskanal 215 der beiden nebeneinander angeordneten Zirkulationskanäle 215 des Basismoduls 200 angeschlossen. Jedes der an das Basismodul 200 angeschlossenen Funktionsmodule 300 ist somit ausschließlich an einem Zirkulationskanal 215 des Basismoduls 200 angeschlossen und fluidtechnisch mit diesem verbunden. Der Verlauf eines zirkulierenden Luftstroms innerhalb des Zirkulationskreislaufs 101 erfolgt hingegen analog zu der zu Fig. 8 beschriebenen Ausführungsform.

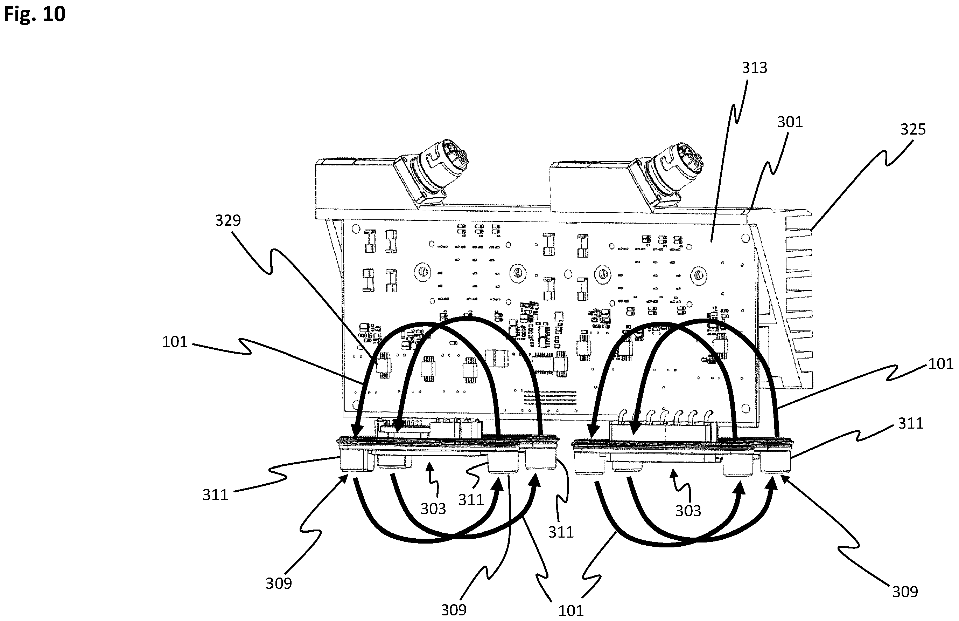

Fig. 10 zeigt eine weitere schematische Innenansicht des Funktionsmoduls 300 in Fig. 5.

In Fig. 10 ist das Innere des Funktionsgehäuses 301 des Funktionsmoduls 300 gemäß der Ausführungsformen in Figuren 5 bis 8 dargestellt. Darüber hinaus ist ein möglicher Verlauf eines zirkulierenden Luftstroms innerhalb des Funktionsgehäuses 301 dargestellt. Ein entsprechendes Basismodul 200 ist in Fig. 10 nicht dargestellt, sodass der Verlauf des zirkulierenden Luftstroms innerhalb des Zirkulationskanals 215 des jeweiligen Basismoduls 200 lediglich schematisch angedeutet ist.

In Fig. 10 ist dargestellt, wie ein zirkulierender Luftstrom durch Kopplungsöffnungen 309 der Funktionsanschlusselemente 303 des Funktionsmoduls 300 in das Innere des Funktionsgehäuses 301 eintritt und entlang der elektronischen Funktionsschaltung 313, die im Inneren des Funktionsgehäuses 301 angeordnet ist, entlangströmt. Hierbei können mögliche Wärmestaunester, die im Bereich einzelner Komponenten 329 der elektronischen Funktionsschaltung 313 auftreten können, verwirbelt und zerstreut werden. Der durch die Kopplungsöffnungen 309 der Funktionsanschlusselemente 303 in das Innere des Funktionsgehäuses 301 eintretende zirkulierende Luftstrom tritt durch Kopplungsöffnungen 309 derselben Funktionsanschlusselemente 303 aus dem Funktionsgehäuse 301 wieder aus. Dies erfolgt analog zu dem zu Fig. 8 beschriebenen Prozess.

Da die Kopplungsöffnungen 309 eines Funktionsanschlusselements 303 mit demselben Zirkulationskanal 215, beispielsweise mit dem ersten Teilkanal 219 und dem zweiten Teilkanal 221, verbunden sind, und indem aufgrund der Zirkulation des Luftstroms Druckdifferenzen bestehen, tritt der Luftstrom jeweils nur durch eine Kopplungsöffnung 309 eines Funktionsanschlusselements 303 in das Innere des Funktionsgehäuses 301 ein.

Abweichend zu dem in Fig. 10, wie auch in Fig. 8, dargestellten Verlauf des zirkulierenden Luftstroms innerhalb des Funktionsgehäuses 301 können innerhalb des Funktionsgehäuses 301 mehrere zirkulierende Luftströme sich vermischen und somit durch verschiedene zweite Kopplungsöffnungen 323 aus dem Funktionsgehäuse 301 wieder austreten. Wie bereits zu Fig. 8 erwähnt, ist der Verlauf des zirkulierenden Luftstroms entlang des Zirkulationskreislaufs 101 lediglich schematisch dargestellt und ein tatsächlicher Verlauf kann von den in den Figuren 8 bis 10 dargestellten Verläufen abweichen.

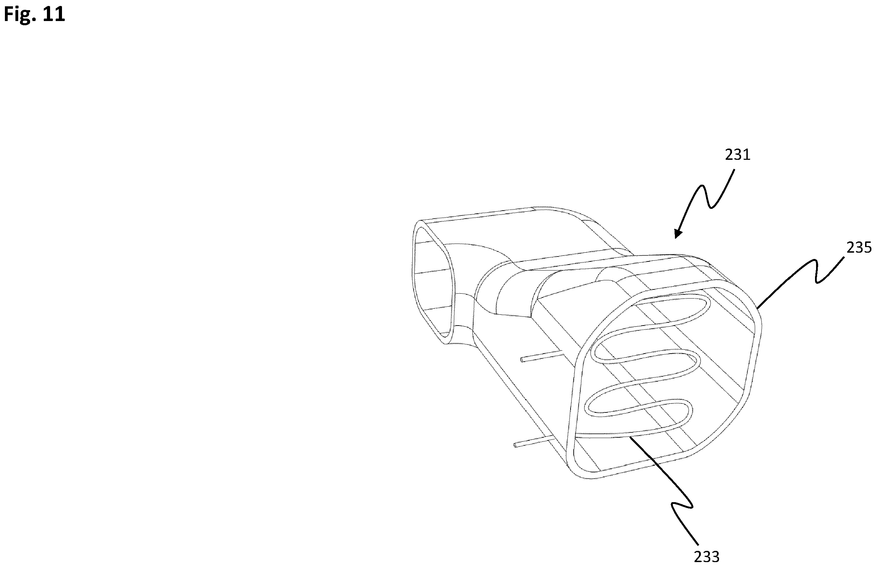

Fig. 11 zeigt eine perspektivische schematische Ansicht eines Heizelements 231 gemäß einer Ausführungsform.

Fig. 11 zeigt ein Heizelement 231, das zum Heizen eines Luftvolumens innerhalb des Zirkulationskreislaufs 101 eingesetzt werden kann. Das Heizelement 231 in der Ausführungsform in Fig. 11 umfasst ein Heizelementgehäuse 235, in dem ein Heizdraht 233 angeordnet ist. Das in Fig. 11 dargestellte Heizelement 231 arbeitet gemäß der Funktionsweise eines Föns, indem sich die zu erwärmende Luft durch das Heizelementgehäuse 235 entlang des Heizdrahts 233 bewegt und dadurch erwärmt wird. Alternativ zu der in Fig. 11 gezeigten Ausführungsform kann das Heizelement 231 eine andere Ausgestaltung aufweisen.

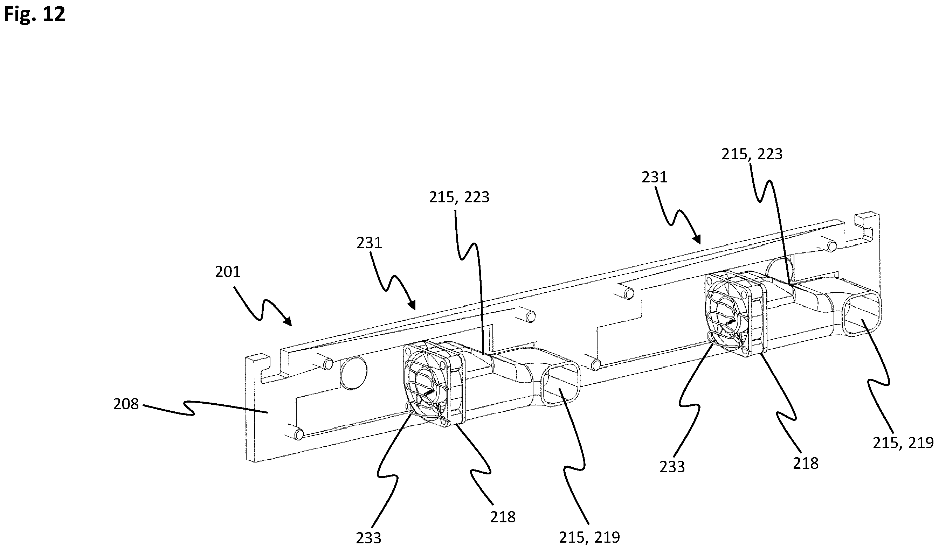

Fig. 12 zeigt eine perspektivische schematische Ansicht des Heizelements 231 in Fig. 11, wobei das Heizelement 231 in ein Basismodul 200 integriert ist.

In Fig. 12 ist das Heizelement 231 in den dritten Teilkanal 223 des Zirkulationskanals 215 des Basismoduls 200 integriert. Hierzu ist in Fig. 12 eine vierte Gehäuseseite 208 des Basisgehäuses 201 dargestellt. Ferner sind für die zwei nebeneinander angeordneten dritten Teilkanäle 323 der zwei nebeneinander angeordneten Zirkulationskanäle 215, die gemäß der Ausführungsformen in Fig. 4 beziehungsweise in den Figuren 7 und 8 ausgebildet sind, zu Darstellungszwecken lediglich Teile der dritten Teilkanäle 223 dargestellt. Neben dem Heizelement 231, das in den dritten Teilkanal 223 integriert ist, ist gemäß der Ausführungsform in Fig. 4 in jedem dritten Teilkanal 223 ein Ventilatorelement 218 angeordnet. Durch das Ventilatorelement 218 kann somit das im Zirkulationskanal 215 befindliche Luftvolumen beschleunigt und zu einer Zirkulation innerhalb des Zirkulationskanals 215 angetrieben werden. Der zur Zirkulation angetriebene Luftstrom strömt somit am Heizdraht 233 des Heizelements 231 entlang, wodurch eine Erwärmung des zirkulierenden Luftstroms und des im Zirkulationskanal 215 beziehungsweise im Zirkulationskreislauf 101 befindlichen Luftvolumens erreicht wird.

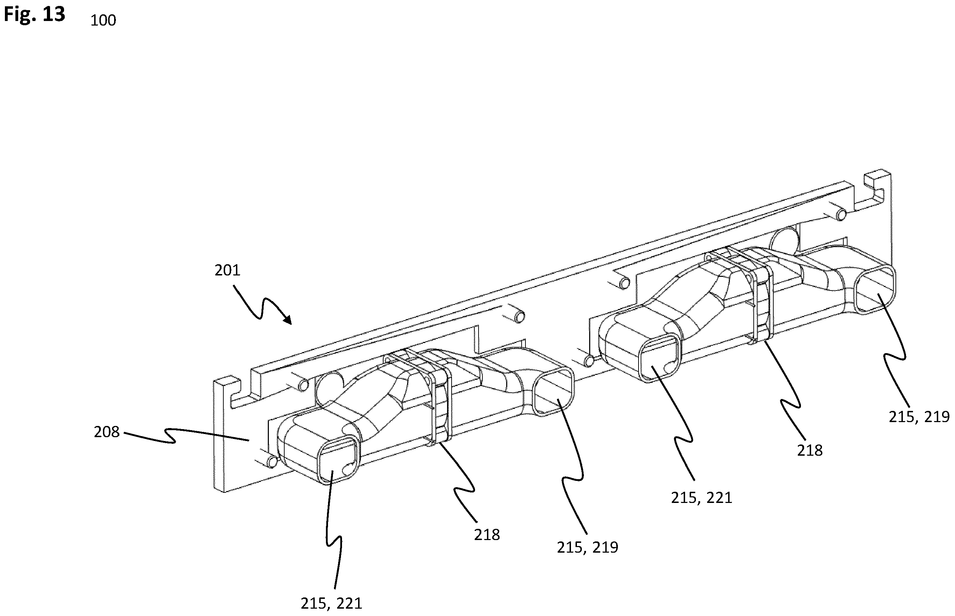

Fig. 13 zeigt eine weitere perspektivische schematische Ansicht des Heizelements 231 in Fig. 11, wobei das Heizelement 231 in ein Basismodul 200 integriert ist.

In Fig. 13 ist die Vervollständigung der in Fig. 12 lediglich teilweise dargestellten dritten Teilkanäle 223 des Zirkulationskanals 215 dargestellt. Das Ventilatorelement 218 wie auch das Heizelement 231 sind in die jeweiligen dritten Teilkanäle 223 vollständig integriert.

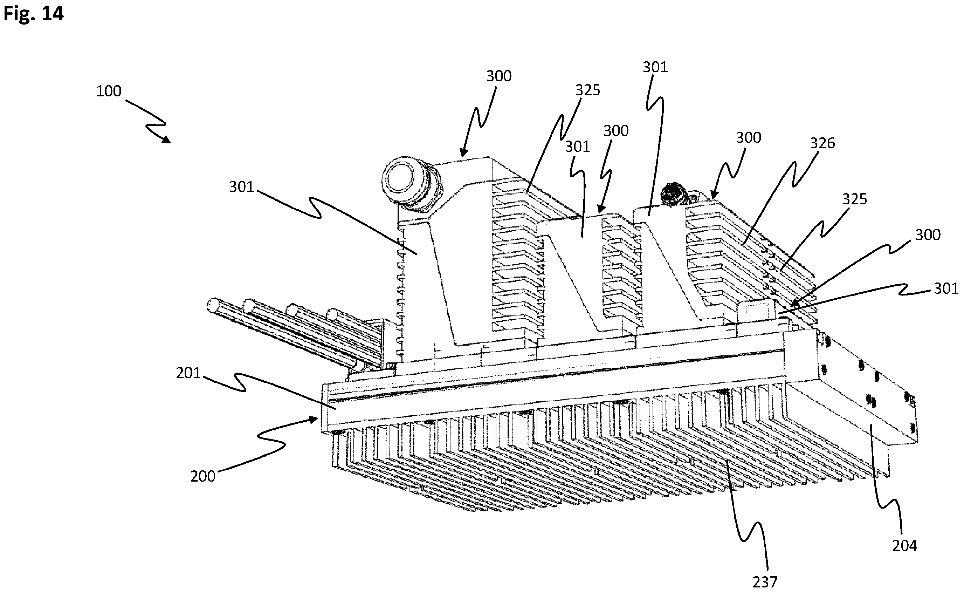

Fig. 14 zeigt eine weitere perspektivische schematische Ansicht eines Schaltschranksystems 100 gemäß einer weiteren Ausführungsform.

In Fig. 14 ist eine Ausführungsform des Schaltschranksystems 100 dargestellt, in der vier Funktionsmodule 300 an einem Basismodul 200 angeschlossen sind. Das Basismodul 200 weist an einer zweiten Gehäuseseite 204 des Basisgehäuses 201 Kühlrippen 237 auf. Über die Kühlrippen 237 kann eine Kühlung des Basisgehäuses 201 des Basismoduls 200 erreicht werden. Darüber hinaus weisen drei der Funktionsmodule 300 an einer Gehäusefläche 326 des Funktionsgehäuses 301 weitere Kühlrippen 325 auf. Über die weiteren Kühlrippen 325 kann eine Kühlung des Funktionsmoduls 300 erreicht werden, indem durch die Vergrößerung der jeweiligen Fläche der Gehäusefläche 326 durch die Ausbildung der weiteren Kühlrippen 325 eine Abstrahlung von Wärme über das Funktionsgehäuse 301 des Funktionsmoduls 300 an die Umgebung des Schaltschranksystems 100 erhöht wird.

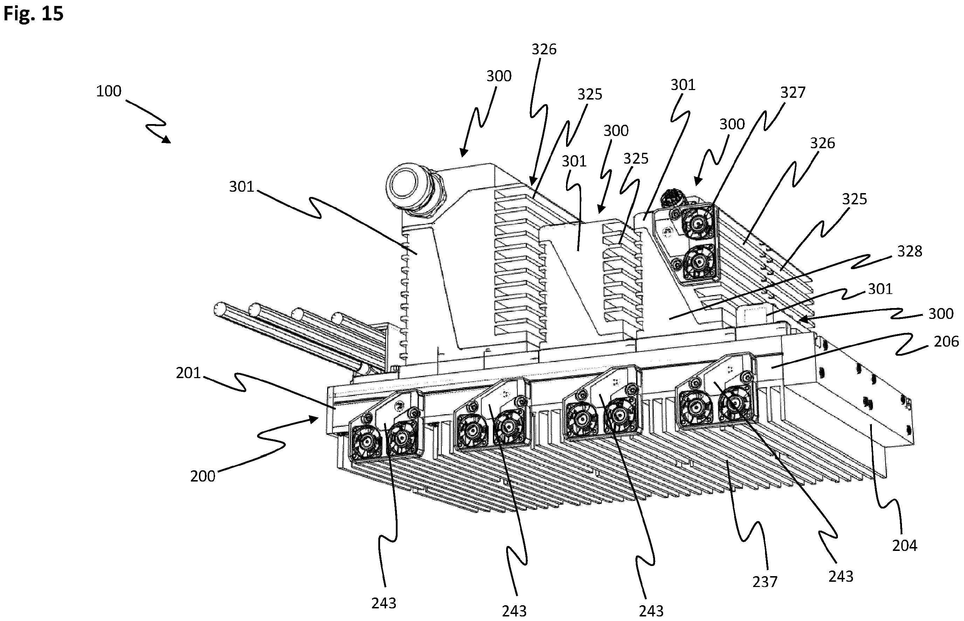

Fig. 15 zeigt eine weitere perspektivische schematische Ansicht eines Schaltschranksystems 100 gemäß einer weiteren Ausführungsform.

In der Ausführungsform in Fig. 15 sind ferner an einer dritten Gehäuseseite 206 des Basisgehäuses 201 des Basismoduls 200 externe Lüfterelemente 243 angeordnet, die ausgebildet sind, eine Kühlluft entlang der Kühlrippen 237 des Basismoduls 200 zu führen. Darüber hinaus weist ein Funktionsmodul 300 an einer weiteren Gehäusefläche 328 weitere externe Lüfterelemente 327 auf, die eingerichtet sind, eine Kühlluft entlang der weiteren Kühlrippen 325 des jeweiligen Funktionsmoduls 300 zu führen.

Alternativ zu der in Fig. 15 gezeigten Ausführungsform kann eine beliebige Anzahl von externen Lüfterelementen 243 am Basismodul 200 angeordnet sein. Darüber hinaus kann eine beliebige Anzahl von weiteren externen Lüfterelementen 327 an den Funktionsmodulen 300 angeordnet sein.

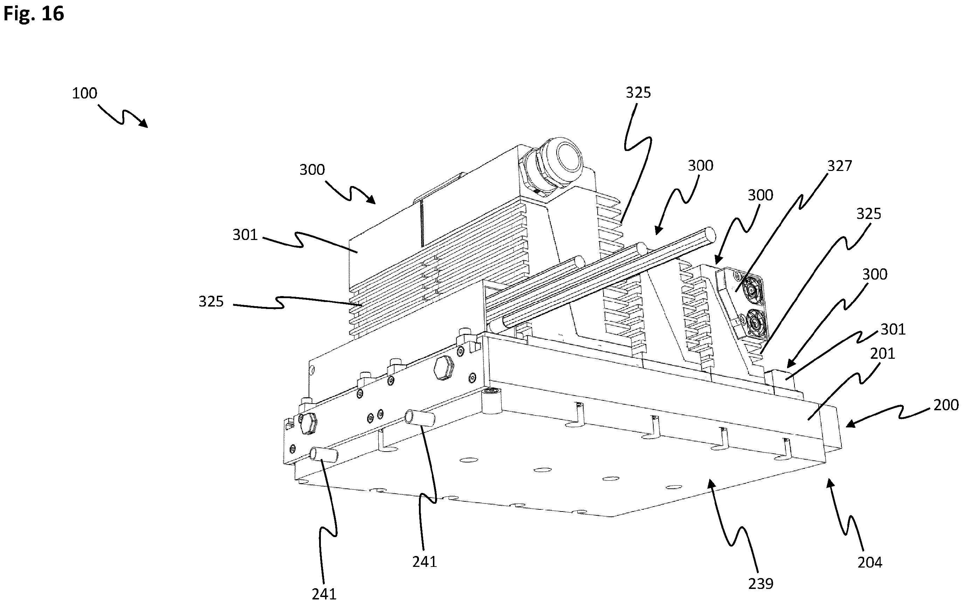

Fig. 16 zeigt eine weitere perspektivische schematische Ansicht eines Schaltschranksystems 100 gemäß einer weiteren Ausführungsform.

In der Ausführungsform in Fig. 16 weist das Basismodul 200 an der zweiten Gehäuseseite 204 anstatt der Kühlrippen 237 eine Wasserkühlung 239 auf. Mittels entsprechender Wasserzufuhrelemente 241 kann Kühlwasser in die Wasserkühlung 239 eingeführt und abgeführt werden, wodurch ein Kühleffekt das Basisgehäuses 201 des Basismoduls 200 und damit verbunden ein Kühleffekt des im Basisgehäuse 201 befindlichen Luftvolumens erreicht wird.

Gemäß einer weiteren Ausführungsform kann das Funktionsgehäuse 301 des Funktionsmoduls 300 beziehungsweise der Funktionsmodule 300 und/oder das Basisgehäuse 201 des Basismoduls 200 aus einem Material gefertigt sein, das eine hohe Wärmeleitfähigkeit von beispielsweise oberhalb 10 W/mK aufweist. Beispielsweise kann das Funktionsgehäuse 301 beziehungsweise das Basisgehäuse 201 aus Metall, insbesondere Stahl, Aluminium oder einer bevorzugten Metalllegierung mit entsprechend hoher Wärmeleitfähigkeit gefertigt sein. Gemäß einer Ausführungsform kann das Funktionsgehäuse 301 des Funktionsmoduls 300 beziehungsweise das Basisgehäuse 201 des Basismoduls 200 mit einer entsprechenden Beschichtung beschichtet sein, die eine hohe Wärmeleitfähigkeit, insbesondere höher als 10 W/mK aufweist. Gemäß einer Ausführungsform kann in dem Basismodul 200 ferner eine Heatpipe ausgebildet sein, mittels der eine Wärmesenke relativ zu den an das Basismodul 200 angeschlossenen Funktionsmodulen 300 realisierbar ist, wobei ein Wärmetransport von den Funktionsmodulen 300 in Richtung der Wärmesenke innerhalb des Basismoduls 200 realisierbar ist. Hierdurch kann ein Kühleffekt der Funktionsmodule 300 erreicht werden.

Gemäß einer weiteren Ausführungsform kann das Basismodul 200 über eine Membran verfügen, die eingerichtet ist, einen Druckausgleich zwischen dem im Basisgehäuse 201 befindlichen Luftvolumen und der das Schaltschranksystem 100 umgebenden Umgebungsluft zu bewirken.

Gemäß einer Ausführungsform kann mittels der oben beschriebenen Mechanismen eine passive oder abgeschlossene aktive Kühlung mit einer Kühlleistung von bis 100 % der Funktionsmodule 300 beziehungsweise des Basismoduls 200 des Schaltschranksystems 100 bis zu einer Umgebungstemperatur von 50°C erreicht werden.

### Bezugszeichenliste

- 100: Schaltschranksystem
- 101: Zirkulationskreislauf

- 200: Basismodul
- 201: Basisgehäuse
- 202: erste Gehäuseseite
- 203: Basisanschlusselemente
- 204: zweite Gehäuseseite
- 205: Basisspannungsanschluss
- 206: dritte Gehäuseseite
- 207: Basisdatenanschluss
- 208: vierte Gehäuseseite
- 209: Spannungsleitung
- 211: Datenleitung
- 213: Anschalteinheit
- 215: Zirkulationskanal
- 217: Zirkulationsöffnung
- 218: Ventilatorelement
- 219: erster Teilkanal
- 221: zweiter Teilkanal
- 223: dritter Teilkanal
- 225: vierter Teilkanal
- 227: erste Zirkulationsöffnung
- 229: zweite Zirkulationsöffnung
- 230: Regulierungsmittel
- 231: Heizelement
- 233: Heizdraht
- 235: Heizelementgehäuse
- 236: Wärmetauscher
- 237: Kühlrippen
- 239: Wasserkühlung
- 241: Wasserzufuhrelement
- 243: externes Lüfterelement

- 300: Funktionsmodul
- 301: Funktionsgehäuse
- 302: Gehäuseunterseite
- 303: Funktionsanschlusselement
- 305: Spannungsanschluss
- 307: Datenanschluss
- 309: Kopplungsöffnung
- 311: Kopplungskragen
- 313: elektronische Funktionsschaltung
- 315: Führungsmittel
- 316: Führungsdüse
- 317: Führungsventilatorelement
- 319: Führungskanal
- 321: erste Kopplungsöffnung
- 323: zweite Kopplungsöffnung
- 325: weitere Kühlrippen
- 326: Gehäusefläche
- 327: weiteres externes Lüfterelement
- 328: weitere Gehäusefläche
- 329: Komponenten der elektronischen Funktionsschaltung

## Patentansprüche

1. Schaltschranksystem (100) mit einem Basismodul (200) und wenigstens einem Funktionsmodul (300), wobei das Basismodul (200) ein Basisgehäuse (201) mit einer ersten Gehäuseseite (202) und einer zweiten Gehäuseseite (204) aufweist, wobei an der ersten Gehäuseseite eine Mehrzahl von Basisanschlusselementen (203) mit Basisspannungsanschlüssen (205) und Basisdatenanschlüssen (207) angeordnet ist, wobei im Basisgehäuse (201) wenigstens eine als Datenbus ausgebildete Datenleitung (211) mit einer Mehrzahl von als Slaveteilnehmer des Datenbus ausgebildeten Anschalteinheiten (213), die über die Datenleitung (211) mit den Basisdatenanschlüssen (207) der Basisanschlusselemente (203) verbunden ist, und wenigstens eine Spannungsleitung (209) angeordnet ist, die mit den Basisspannungsanschlüssen (205) der Basisanschlusselemente (203) verbunden ist, wobei das Funktionsmodul (300) ein Funktionsgehäuse (301) mit einer Gehäuseunterseite (302) aufweist, wobei an der Gehäuseunterseite (302) ein Funktionsanschlusselement (303) mit Spannungsanschlüssen (305) und Datenanschlüssen (307) angeordnet ist, wobei im Funktionsgehäuse (301) wenigstens eine elektronische Funktionsschaltung (313) angeordnet ist, die mit den Spannungsanschlüssen und den Datenanschlüssen des Funktionsanschlusselements (303) verbunden ist, wobei über eine Kopplung des Funktionsanschlusselements (303) mit einem der Basisanschlusselemente (203) das Funktionsmodul (300) mit dem Basismodul (200) verbindbar und eine Verbindung der Spannungsanschlüsse (305) und Datenanschlüsse (307) des Funktionsanschlusselements (303) mit den Basisspannungsanschlüssen (205) und Basisdatenanschlüssen (207) des Basiselements (200) erzielbar ist, wobei im Basisgehäuse (201) ein Zirkulationskanal (215) angeordnet ist, wobei im Zirkulationskanal (215) ein Luftstrom zirkulierbar ist, wobei jedes Basisanschlusselement (203) Zirkulationsöffnungen (217) aufweist, die mit dem Zirkulationskanal (215) fluidtechnisch verbunden sind, wobei das Funktionsanschlusselement (303) Kopplungsöffnungen aufweist, die mit einem Inneren des Funktionsgehäuses (301) fluidtechnisch verbunden sind, wobei die Kopplungsöffnungen (309) mit den Zirkulationsöffnungen (217) koppelbar sind, wobei in einer Kopplung der Kopplungsöffnungen (309) mit den Zirkulationsöffnungen (217) eine fluidtechnische Verbindung zwischen dem Zirkulationskanal (215) und dem Inneren des Funktionsgehäuses (301) besteht und ein fluidtechnisch geschlossener Zirkulationskreislauf (101) umfassend den Zirkulationskanal (215) und das Innere des Funktionsgehäuses (301) gebildet ist, in dem durch eine Druckdifferenz innerhalb des Funktionsgehäuses (301) des Funktionsmoduls (300) und/oder des Zirkulationskanals (215) des Basismoduls (200) ein Luftstrom zirkulierbar ist, indem der Luftstrom über eine Kopplungsöffnung (309) aus dem Zirkulationskanal (215) in das Innere des Funktionsgehäuses (301) eintritt und über eine weitere Kopplungsöffnung (309) aus dem Inneren des Funktionsgehäuses (301) wieder in den Zirkulationskanal (215) strömt.

2. Schaltschranksystem (100) nach Anspruch 1, ferner umfassend ein Ventilatorelement (218), wobei das Ventilatorelement (218) in den fluidtechnischen Zirkulationskreislauf (101) integriert ist, und wobei das Ventilatorelement (218) ausgebildet ist, innerhalb des Zirkulationskreislaufs (101) den zirkulierenden Luftstrom zu beschleunigen.

3. Schaltschranksystem (100) nach Anspruch 2, wobei das Ventilatorelement (218) im Funktionsgehäuse (301) des Funktionsmoduls (300) und/oder innerhalb des Zirkulationskanals (215) des Basismoduls (200) angeordnet ist.

4. Schaltschranksystem (100) nach einem der voranstehenden Ansprüche, wobei an den Zirkulationsöffnungen (217) Regulierungsmittel (230) angeordnet sind, wobei die Regulierungsmittel (230) ausgebildet sind, ein Volumen eines durch die Zirkulationsöffnungen (217) strömenden Luftstroms zu regulieren.

5. Schaltschranksystem (100) nach einem der voranstehenden Ansprüche, wobei jede Kopplungsöffnung (309) jeweils einen Kopplungskragen (311) aufweist, wobei der Kopplungskragen (311) die Kopplungsöffnung (309) umgibt und von dem Funktionsanschlusselement (303) hervorsteht, wobei der Kopplungskragen (311) in eine Zirkulationsöffnung (217) einführbar ist und eine Kopplung zwischen der Kopplungsöffnung (309) und der Zirkulationsöffnung (217) ermöglicht, und wobei durch die Kopplung zwischen den Kopplungsöffnungen (309) und den Zirkulationsöffnungen (217) eine fluiddichte Verbindung zwischen dem Funktionsmodul (300) und dem Basismodul (200) erreicht ist.

6. Schaltschranksystem (100) nach einem der voranstehenden Ansprüche, wobei an den Zirkulationsöffnungen (217) Dichtungsmittel angeordnet sind, und wobei die Dichtungsmittel ausgebildet sind, die Zirkulationsöffnungen (217) der Basisanschlusselemente (203) fluidtechnisch zu verschließen, an denen keine Funktionsmodule (300) angeschlossen sind.

7. Schaltschranksystem (100) nach einem der voranstehenden Ansprüche, wobei im Inneren des Funktionsgehäuses (301) des Funktionsmoduls (300) Führungsmittel (315) angeordnet sind, wobei die Führungsmittel (315) ausgebildet sind, einen durch die Kopplungsöffnungen (309) in das Innere des Funktionsgehäuses (301) strömenden Luftstrom in einen vorbestimmten Bereich innerhalb des Funktionsgehäuses (301) zu führen, in dem wenigstens eine Komponente (329) der elektrischen Funktionsschaltung (313) angeordnet ist.

8. Schaltschranksystem (100) nach Anspruch 7, wobei die Führungsmittel (315) an den Kopplungsöffnungen (309) angeordnete Führungsdüsen (316) umfassen, die geeignet sind, den Luftstrom in den vorbestimmten Bereich innerhalb des Funktionsgehäuses (301) zu führen, und/oder wobei die Führungsmittel (315) ein im Inneren des Funktionsgehäuses (301) angeordnetes Führungsventilatorelement (317) umfassen, und/oder wobei die Führungsmittel (315) einen Führungskanal (319) umfassen, wobei der Führungskanal eine fluidtechnische Verbindung zu wenigstens einer der Kopplungsöffnungen (309) aufweist, und wobei der Führungskanal ausgebildet ist, den Luftstrom in einen vorbestimmten Bereich innerhalb des Inneren des Funktionsgehäuses (301) zu führen.

9. Schaltschranksystem (100) nach einem der voranstehenden Ansprüche, wobei der Zirkulationskanal (215) in einem thermischen Kontakt mit wenigstens einer Gehäuseinnenwand des Basisgehäuses (301) des Basismoduls (200) steht, und/oder wobei das Schaltschranksystem (100) ferner ein Heizelement (231) umfasst, wobei das Heizelement (231) in den fluidtechnischen Zirkulationskreislauf (101) integriert ist, wobei das Heizelement (231) eingerichtet ist, ein vom Zirkulationskreislauf (101) umfasstes Luftvolumen zu heizen, und wobei das Heizelement (231) innerhalb des Funktionsgehäuses (301) des Funktionselements und/oder innerhalb des Zirkulationskanals (215) angeordnet ist, und/oder wobei das Schaltschranksystem (100) ferner einen Wärmetauscher (235) umfasst, wobei der Wärmetauscher (235) in den Zirkulationskreislauf (101) integriert ist, wobei der Wärmetauscher (235) eingerichtet ist, den Luftstrom innerhalb des Zirkulationskreislaufs (101) zu kühlen, wobei der Wärmetauscher (235) ein Luft-Luft-Wärmetauscher oder ein Luft-Wasser-Wärmetauscher ist, und wobei der Wärmetauscher (235) im Inneren des Funktionsgehäuses (301) des Funktionsmoduls (300) und/oder im Inneren des Basisgehäuses (301) des Basismoduls (200) angeordnet ist, und/oder wobei an der zweiten Gehäuseseite (204) des Basisgehäuses des Basismoduls (200) Kühlrippen (237) und/oder eine Wasserkühlung (239) ausgebildet ist, und/oder wobei an einer Gehäusefläche (326) des Funktionsmoduls (300) weitere Kühlrippen (325) ausgebildet sind, und/oder wobei an einer dritten Gehäusefläche (206) des Basismoduls (200) ein externes Lüfterelement (243) ausgebildet ist, wobei das externe Lüfterelement (243) eingerichtet ist, Kühlluft entlang der Kühlrippen (237) zu führen, und/oder wobei an einer weiteren Gehäusefläche (326) des Funktionsmoduls (300) ein weiteres externes Lüfterelement (327) ausgebildet ist, wobei das weitere externe Lüfterelement (327) eingerichtet ist, Kühlluft entlang der weiteren Kühlrippen (325) zu führen.

10. Schaltschranksystem (100) nach einem der voranstehenden Ansprüche, wobei der Zirkulationskanal (215) einen ersten Teilkanal (219), einen zweiten Teilkanal (221), einen dritten Teilkanal (223) und einen vierten Teilkanal (225) umfasst, wobei der erste Teilkanal (219) und der zweite Teilkanal (221) parallel zueinander angeordnet sind, wobei der dritte Teilkanal (223) und der vierte Teilkanal (225) parallel zueinander angeordnet sind, wobei jedes Basisanschlusselement (203) eine erste Zirkulationsöffnung (227) und eine zweite Zirkulationsöffnung (229) aufweist, wobei die erste Zirkulationsöffnung (227) mit dem ersten Teilkanal (225) und die zweite Zirkulationsöffnung (229) mit dem zweiten Teilkanal (225) fluidtechnisch verbunden sind, wobei das Funktionsanschlusselement (303) eine erste Kopplungsöffnung (321) und eine zweite Kopplungsöffnung (323) aufweist, wobei die erste Kopplungsöffnung (321) und die zweite Kopplungsöffnung (323) jeweils fluidtechnisch mit einem Inneren des Funktionsgehäuses (301) verbunden sind, wobei die erste Kopplungsöffnung (321) mit der ersten Zirkulationsöffnung (229) und die zweite Kopplungsöffnung (323) mit der zweiten Zirkulationsöffnung (229) koppelbar sind, und wobei durch den durch eine Temperaturdifferenz innerhalb des Funktionsgehäuses (301) oder innerhalb des Zirkulationskanals (215) oder durch das Ventilatorelement (218) erzeugten zirkulierenden Luftstrom zwischen dem ersten Teilkanal (219) und dem zweiten Teilkanal (221) eine Druckdifferenz erzielbar ist.

11. Schaltschranksystem (100) nach Anspruch 10, wobei die erste Kopplungsöffnung (321) und die zweite Kopplungsöffnung (323) an zwei gegenüberliegenden äußersten Enden des Funktionsanschlusselements (303) angeordnet sind, und wobei die Datenanschlüsse (307) und Spannungsanschlüsse (305) am Funktionsanschlusselement (303) zwischen der ersten Kopplungsöffnung (321) und die zweite Kopplungsöffnung (323) angeordnet sind.

12. Schaltschranksystem (100) nach einem der voranstehenden Ansprüche, wobei im Inneren des Funktionsgehäuses (301) ein internes Lüfterelement angeordnet ist, wobei das interne Lüfterelement eingerichtet ist, Kühlluft entlang wenigstens einer Innenwand des Funktionsgehäuses (301) zu führen, und/oder wobei in einem Inneren des Basisgehäuses (201) ein weiteres internes Lüfterelement angeordnet ist, wobei das weitere interne Lüfterelement eingerichtet ist, Kühlluft entlang wenigstens einer Innenwand des Basisgehäuses (201) zu führen.

13. Schaltschranksystem (100) nach einem der voranstehenden Ansprüche, wobei Komponenten (329) der elektronischen Funktionsschaltung (313) des Funktionsmoduls (300) einen thermischen Kontakt zu einer Gehäuseinnenwand des Funktionsgehäuses (301) aufweisen, und/oder wobei das Funktionsgehäuse (301) und/oder das Basisgehäuse (201) aus einem Material mit einer Wärmeleitfähigkeit von wenigstens 10 W/mK gefertigt sind, und/oder wobei das Funktionsgehäuse (301) und/oder das Basisgehäuse (201) mit einer Beschichtung mit einer Wärmeleitfähigkeit von wenigstens 10 W/mK beschichtet sind.

14. Funktionsmodul (300) für ein Schaltschranksystem (100) nach einem der voranstehenden Ansprüche 1 bis 13, wobei das Funktionsmodul (300) ein Funktionsgehäuse (301) mit einer Gehäuseunterseite (302) aufweist, wobei an der Gehäuseunterseite (302) ein Funktionsanschlusselement (303) mit Spannungsanschlüssen(305) und Datenanschlüssen (307) angeordnet ist, wobei im Funktionsgehäuse (301) wenigstens eine elektronische Funktionsschaltung (313) angeordnet ist, die mit den Spannungsanschlüssen (305) und den Datenanschlüssen (307) des Funktionsanschlusselements (303) verbunden ist, wobei über eine Kopplung des Funktionsanschlusselements (303) mit einem Basisanschlusselement (203) eines Basismoduls (200) des Schaltschranksystems (100) das Funktionsmodul (300) mit dem Basismodul (200) verbindbar und eine Verbindung der Spannungsanschlüsse (305) und Datenanschlüsse (307) des Funktionsanschlusselements (303) mit den Basisspannungsanschlüssen (205) und Basisdatenanschlüssen (207) des Basiselements (200) erzielbar ist, wobei das Funktionsanschlusselement (303) Kopplungsöffnungen (309) aufweist, wobei die Kopplungsöffnungen (309) mit einem Inneren des Funktionsgehäuses (301) fluidtechnisch verbunden sind, wobei die Kopplungsöffnungen (309) mit Zirkulationsöffnungen (217) eines Basismoduls (200) des Schaltschranksystems koppelbar sind, und wobei in einer Kopplung der Kopplungsöffnungen (309) mit den Zirkulationsöffnungen (217) eine fluidtechnische Verbindung zwischen einem Zirkulationskanal (215) des Basismoduls (200) und dem Inneren des Funktionsgehäuses (301) erzielbar ist und ein fluidtechnisch geschlossener Zirkulationskreislauf (101) umfassend den Zirkulationskanal (215) und das Innere des Funktionsgehäuses (301) bildbar ist, in dem ein Luftstrom zirkulierbar ist, indem der Luftstrom über eine Kopplungsöffnung (309) aus dem Zirkulationskanal (215) in das Innere des Funktionsgehäuses (301) eintritt und über eine weitere Kopplungsöffnung (309) aus dem Inneren des Funktionsgehäuses (301) wieder in den Zirkulationskanal (215) strömt.

## Claims

1. A control-cabinet system (100) having a base module (200) and at least a functional module (300), the base module (200) comprising a base housing (201) with a first housing face (202) and a second housing face (204), wherein a plurality of base connection elements (203) with base voltage connections (205) and base data connections (207) are arranged at the first housing face, wherein at least one data line (211) embodied as a data bus with a plurality of switch-on units (213) embodied as a slave subscriber of the data bus, which is connected to the base data connections (207) of the base connection elements (203) via the data line (211), is arranged in the base housing (201) and at least one voltage line (209) is arranged which is connected to the base voltage connections (205) of the base connection elements (203), wherein the functional module (300) comprises a functional housing (301) with a housing underside (302), wherein a functional connection element (303) with voltage connections (305) and data connections (307) is arranged on the housing underside (302), wherein at least one electronic functional circuit (313), which is connected to the voltage connections and the data connections of the functional connection element (303), is arranged in the functional housing (301), wherein the functional module (300) may be connected to the base module (200) via a coupling of the functional connection element (303) to one of the base connection elements (203) and a connection of the voltage connections (305) and data connections (307) of the functional connection element (303) to the base voltage connections (205) and base data connections (207) of the base element (200) may be achieved, wherein a circulation channel (215) is arranged in the base housing (201), wherein an air flow may be circulated in the circulation channel (215), wherein each base connection element (203) comprises circulation openings (217) which are fluidically connected to the circulation channel (215), wherein the functional connection element (303) has coupling openings fluidically connected to an interior of the functional housing (301), wherein the coupling openings (309) may be coupled to the circulation openings (217), and wherein, in a coupling of the coupling openings (309) with the circulation openings (217), a fluidic connection exists between the circulation channel (215) and the interior of the functional housing (301), and a fluidically closed circulation circuit (101) comprising the circulation channel (215) and the interior of the functional housing (301) is formed, in which due to a pressure difference within the functional housing (301) of the functional module (300) and/or the circulation channel (215) of the base module (200) an air flow may be circulated by the air entering into the interior of the functional housing (302) from the circulation channel (215) via a coupling opening and flowing back into the circulation channel (215) from the interior of the functional housing (301) via a further coupling opening (309).

2. The control-cabinet system (100) according to claim 1, further comprising a fan element (218), wherein the fan element (218) is integrated into the fluidic circulation circuit (101), and wherein the fan element (218) is embodied to accelerate the circulating airflow within the circulation circuit (101).

3. The control-cabinet system (100) according to claim 2, wherein the fan element (218) is arranged in the functional housing (301) of the functional module (300) and/or within the circulation channel (215) of the base module (200).

4. The control-cabinet system (100) according to any one of the preceding claims, wherein regulating devices (230) are arranged at the circulation openings (217), wherein the regulating devices (230) are embodied to regulate a volume of an air flow passing through the circulation openings (217).

5. The control-cabinet system (100) according to any one of the preceding claims, wherein each coupling opening (309) comprises a respective coupling collar (311), wherein the coupling collar (311) surrounds the coupling opening (309) and protrudes from the functional connection element (303), wherein the coupling collar (311) may be inserted into a circulation opening (217) and allows for coupling between the coupling opening (309) and the circulation opening (217), and wherein a fluid-tight connection between the functional module (300) and the base module (200) is achieved by the coupling between the coupling openings (309) and the circulation openings (217).

6. The control-cabinet system (100) according to any one of the preceding claims, wherein sealing devices are arranged at the circulation openings (217), and wherein the sealing devices are embodied to fluidically seal off the circulation openings (217) of the base connection elements (203) to which no functional modules (300) are connected.

7. The control-cabinet system (100) according to any one of the preceding claims, wherein guiding devices (315) are arranged inside of the functional housing (301) of the functional module (300), wherein the guiding devices (315) are configured to guide an air flow flowing through the coupling openings (309) into the interior of the functional housing (301) into a predetermined area inside the functional housing (301), in which at least one component (329) of the electrical function circuit (313) is arranged.

8. The control-cabinet system (100) according to claim 7, wherein the guiding devices (315) comprise guiding nozzles (316) arranged at the coupling openings (309) and suitable to guide the air flow into the predetermined area within the functional housing (301), and wherein the guiding devices (315) comprise a guiding fan element (317) arranged inside of the functional housing (301), wherein the guiding channel has a fluidic connection to at least one of the coupling openings (309), and wherein the guiding channel is embodied to guide the airflow into a predetermined region within the interior of the functional housing (301).

9. The control-cabinet system (100) according to any one of the preceding claims, wherein the circulation channel (215) is in a thermal contact with at least one inner housing wall of the base housing (301) of the base module (200), and/or wherein the control-cabinet system (100) further comprises a heating element (231), wherein the heating element (231) is integrated into the fluidic circulation circuit (101), wherein the heating element (231) is embodied to heat a volume of air comprised by the circulation circuit (101), and wherein the heating element (231) is arranged within the functional housing (301) of the functional element and/or within the circulation channel (215), and/or wherein the control-cabinet system (100) further comprises a heat exchanger (235), wherein the heat exchanger (235) is integrated into the circulation circuit (101), wherein the heat exchanger (235) is embodied to cool the airflow within the circulation circuit (101), wherein the heat exchanger (235) is an air-to-air heat exchanger or an air-to-water heat exchanger, and wherein the heat exchanger (235) is arranged inside of the functional housing (301) of the functional module (300) and/or inside of the base housing (301) of the base module (200), and/or wherein cooling fins (237) and/or a water-cooling system (239) are embodied at the second housing face (204) of the base housing of the base module (200), and/or wherein further cooling fins (325) are embodied on a housing surface (326) of the functional module (300), and/or wherein an external fan element (243) is embodied on a third housing surface (206) of the base module (200), wherein the external fan element (243) is configured to guide cooling air along the cooling fins (237), and/or wherein a further external fan element (327) is embodied at a further housing surface (326) of the functional module (300), wherein the further external fan element (327) is set up to guide cooling air along the further cooling fins (325).

10. The control-cabinet system (100) according to any one of the preceding claims, wherein the circulation channel (215) comprises a first partial channel (219), a second partial channel (221), a third partial channel (223) and a fourth partial channel (225), wherein the first partial channel (219) and the second partial channel (221) are arranged in parallel to each other, wherein the third partial channel (223) and the fourth partial channel (225) are arranged in parallel to each other, wherein each base connection element (203) comprises a first circulation opening (227) and a second circulation opening (229), wherein the first circulation opening (227) is fluidically connected to the first partial channel (225) and the second circulation opening (229) is fluidically connected to the second partial channel (225), wherein the functional connection element (303) comprises a first coupling opening (321) and a second coupling opening (323), wherein the first coupling opening (321) and the second coupling opening (323) are each fluidically connected to an interior of the functional housing (301), wherein the first coupling opening (321) may be coupled to the first circulation opening (229) and the second coupling opening (323) may be coupled to the second circulation opening (229), and wherein a pressure difference may be achieved by the circulating air flow between the first partial channel (219) and the second partial channel (221) generated due to a temperature difference within the functional housing (301) or within the circulation channel (215) or by the fan element (298).

11. The control-cabinet system (100) according to claim 10, wherein the first coupling opening (321) and the second coupling opening (323) are arranged at two opposite outermost ends of the functional connection element (303), and wherein the data connections (307) and voltage connections (305) are arranged at the functional connection element (303) between the first coupling opening (321) and the second coupling opening (323).

12. The control-cabinet system (100) according to any one of the preceding claims, wherein an internal fan element is arranged in the interior of the functional housing (301), wherein the internal fan element is configured to guide cooling air along at least one inner wall of the functional housing (301), and/or wherein a further internal fan element is arranged in an interior of the base housing (201), wherein the further internal fan element is configured to guide cooling air along at least one inner wall of the base housing (201).

13. The control-cabinet system (100) according to any one of the preceding claims, wherein components (329) of the electronic functional circuit (313) of the functional module (300) comrpise a thermal contact to a housing inner wall of the functional housing (301), and/or wherein the functional housing (301) and/or the base housing (201) are made of a material having a thermal conductivity of at least 10 W/mK, and/or wherein the functional housing (301) and/or the base housing (201) are coated with a coating having a thermal conductivity of at least 10 W/mK.

14. A functional module (300) for a control-cabinet system (100) according to any one of the preceding claims 1 to 13, wherein the functional module (300) comprises a functional housing (301) with a housing underside (302), wherein a functional connection element (303) having voltage connections (305) and data connections (307) being arranged at the housing underside (302), wherein at least an electronic functional circuit (313) is arranged in the functional housing (301), being connected to the voltage connections (305) and the data connections (307) of the functional connection element (303), wherein the functional module (300) may be connected to the base module (200) via a coupling of the functional connection element (303) to a base connection element (203) of a base module (200) of the control-cabinet system (100), and a connection of the voltage connections (305) and data connections (307) of the functional connection element (303) to the base voltage connections (205) and base data connections (207) of the base element (200) may be achieved, wherein the functional connection element (303) comprises coupling openings (309), wherein the coupling openings (309) are fluidically connected to an interior of the functional housing (301), wherein the coupling openings (309) may be coupled to circulation openings (217) of a base module (200) of the control-cabinet system and wherein in a coupling of the coupling openings (309) having the circulation openings (217) a fluidic connection between a circulation channel (215) of the base module (200) and the interior of the functional housing (301) may be achieved and a fluidically closed circulation circuit (101) comprising the circulation channel (215) and the interior of the functional housing (301) may be formed, in which an air flow may be circulated by the air entering into the interior of the functional housing (302) from the circulation channel (215) via a coupling opening and flowing back into the circulation channel (215) from the interior of the functional housing (301) via a further coupling opening (309).

## Revendications

1. Système d'armoire de commande (100) comprenant un module de base (200) et au moins un module fonctionnel (300), le module de base (200) comportant un boîtier de base (201) pourvu d'un premier côté de boîtier (202) et d'un deuxième côté de boîtier (204), une pluralité d'éléments de raccordement de base (203) pourvus de bornes de tension de base (205) et de bornes de données de base (207) étant disposés sur le premier côté de boîtier, au moins une ligne de données (211), qui est conçue comme un bus de données et pourvue d'une pluralité d'unités de commutation (213) conçues comme des périphériques esclaves du bus de données et reliées par le biais de la ligne de données (211) aux bornes de données de base (207) des éléments de raccordement de base (203), et au moins une ligne de tension (209), qui est reliée aux bornes de tension de base (205) des éléments de raccordement de base (203), étant disposées dans le boîtier de base (201), le module fonctionnel (300) comportant un boîtier fonctionnel (301) pourvu d'un côté de boîtier inférieur (302), un élément de raccordement fonctionnel (303) pourvu de bornes de tension (305) et de bornes de données (307) étant disposé sur le côté de boîtier inférieur (302), au moins un circuit fonctionnel électronique (313), qui est relié aux bornes de tension et aux bornes de données de l'élément de raccordement fonctionnel (303), étant disposé dans le boîtier fonctionnel (301), le module fonctionnel (300) pouvant être relié au module de base (200) par accouplement de l'élément de raccordement fonctionnel (303) à l'un des éléments de raccordement de base (203) et une liaison des bornes de tension (305) et des bornes de données (307) de l'élément de raccordement fonctionnel (303) pouvant être établie avec les bornes de tension de base (205) et les bornes de données de base (207) de l'élément de base (200), un conduit de circulation (215) étant disposé dans le boîtier de base (201), un flux d'air pouvant circuler dans le conduit de circulation (215), chaque élément de raccordement de base (203) comportant des ouvertures de circulation (217) qui sont en communication fluidique avec le conduit de circulation (215), l'élément de raccordement fonctionnel (303) comportant des ouvertures d'accouplement qui sont en communication fluidique avec un intérieur du boîtier fonctionnel (301), les ouvertures d'accouplement pouvant être accouplées aux ouvertures de circulation (217), une liaison fluidique étant établie entre le conduit de circulation (215) et l'intérieur du boîtier fonctionnel (301) lors d'un accouplement des ouvertures d'accouplement (309) avec les ouvertures de circulation (217), et un circuit de circulation (101) qui est fluidiquement fermé et qui comprend le conduit de circulation (215) et l'intérieur du boîtier fonctionnel (301) étant formé dans lequel un flux d'air peut circuler par une différence de pression à l'intérieur du boîtier fonctionnel (301) du module fonctionnel (300) et/ou du conduit de circulation (215) du module de base (200) en ce que le flux d'air quitte le conduit de circulation (215) par une ouverture d'accouplement (309) pour entrer à l'intérieur du boîtier fonctionnel (301) et s'écoule de l'intérieur du boîtier fonctionnel (301) de nouveau dans le conduit de circulation (215) par une autre ouverture d'accouplement (309).

2. Système d'armoire de commande (100) selon la revendication 1, comprenant en outre un élément formant ventilateur (218), l'élément formant ventilateur (218) étant intégré dans le circuit de circulation de fluide (101), et l'élément formant ventilateur (218) étant conçu pour accélérer le flux d'air en circulation à l'intérieur du circuit de circulation (101).

3. Système d'armoire de commande (100) selon la revendication 2, l'élément formant ventilateur (218) étant disposé dans le boîtier fonctionnel (301) du module fonctionnel (300) et/ou à l'intérieur du conduit de circulation (215) du module de base (200).

4. Système d'armoire de commande (100) selon l'une des revendications précédentes, des moyens de régulation (230) étant disposés au niveau des ouvertures de circulation (217), les moyens de régulation (230) étant conçus pour réguler un volume d'un flux d'air circulant à travers les ouvertures de circulation (217) .

5. Système d'armoire de commande (100) selon l'une des revendications précédentes, chaque ouverture d'accouplement (309) comportant une collerette d'accouplement (311), la collerette d'accouplement (311) entourant l'ouverture d'accouplement (309) et saillant de l'élément de raccordement fonctionnel (303), la collerette d'accouplement (311) pouvant être insérée dans une ouverture de circulation (217) et permettant un accouplement entre l'ouverture d'accouplement (309) et l'ouverture de circulation (217), et une liaison étanche aux fluides étant établie entre le module fonctionnel (300) et le module de base (200) par l'accouplement entre les ouvertures d'accouplement (309) et les ouvertures de circulation (217) .

6. Système d'armoire de commande (100) selon l'une des revendications précédentes, des moyens d'étanchéité étant disposés au niveau des ouvertures de circulation (217), et les moyens d'étanchéité étant conçus pour fermer fluidiquement les ouvertures de circulation (217) des éléments de raccordement de base (203) auxquels aucun module fonctionnel (300) n'est raccordé.

7. Système d'armoire de commande (100) selon l'une des revendications précédentes, des moyens de guidage (315) étant disposés à l'intérieur du boîtier fonctionnel (301) du module fonctionnel (300), les moyens de guidage (315) étant conçus pour guider un flux d'air circulant à travers les ouvertures d'accouplement (309) vers l'intérieur du boîtier fonctionnel (301) dans une zone prédéterminée à l'intérieur du boîtier fonctionnel (301) dans laquelle au moins un composant (329) du circuit fonctionnel électrique (313) est disposé.

8. Système d'armoire de commande (100) selon la revendication 7, les moyens de guidage (315) comprenant des buses de guidage (316) qui sont disposées au niveau des ouvertures d'accouplement (309) et qui sont adaptées pour guider le flux d'air dans la zone prédéterminée à l'intérieur du boîtier fonctionnel (301), et/ou les moyens de guidage (315) comprenant un élément formant ventilateur de guidage (317) disposé à l'intérieur du boîtier fonctionnel (301), et/ou les moyens de guidage (315) comprenant un conduit de guidage (319), le conduit de guidage comportant une liaison fluidique avec au moins l'une des ouvertures d'accouplement (309), et le conduit de guidage étant conçu pour guider le flux d'air jusque dans une zone prédéterminée à l'intérieur du boîtier fonctionnel (301) .

9. Système d'armoire de commande (100) selon l'une des revendications précédentes, le conduit de circulation (215) étant en contact thermique avec au moins une paroi intérieure du boîtier de base (301) du module de base (200), et/ou le système d'armoire de commande (100) comprenant en outre un élément chauffant (231), l'élément chauffant (231) étant intégré dans le circuit de circulation de fluide (101), l'élément chauffant (231) étant conçu pour chauffer un volume d'air entouré par le circuit de circulation (101), et l'élément chauffant (231) étant disposé à l'intérieur du boîtier fonctionnel (301) de l'élément fonctionnel et/ou à l'intérieur du conduit de circulation (215), et/ou le système d'armoire de commande (100) comprenant en outre un échangeur de chaleur (235), l'échangeur de chaleur (235) étant intégré dans le circuit de circulation (101), l'échangeur de chaleur (235) étant conçu pour refroidir le flux d'air à l'intérieur du circuit de circulation (101), l'échangeur de chaleur (235) étant un échangeur de chaleur air-air ou un échangeur de chaleur air-eau, et l'échangeur de chaleur (235) étant disposé à l'intérieur du boîtier fonctionnel (301) du module fonctionnel (300) et/ou à l'intérieur du boîtier de base (301) du module de base (200), et/ou des ailettes de refroidissement (237) et/ou un refroidissement par eau (239) étant formés sur le deuxième côté (204) du boîtier de base du module de base (200), et/ou d'autres ailettes de refroidissement (325) étant formées sur une surface de boîtier (326) du module fonctionnel (300), et/ou un élément formant ventilateur extérieur (243) étant formé sur une troisième surface de boîtier (206) du module de base (200), l'élément formant ventilateur extérieur (243) étant conçu pour guider l'air de refroidissement le long des ailettes de refroidissement (237), et/ou un autre élément formant ventilateur extérieur (327) étant formé sur une autre surface de boîtier (326) du module fonctionnel (300) , l'autre élément formant ventilateur extérieur (327) étant conçu pour guider l'air de refroidissement le long des autres ailettes de refroidissement (325).

10. Système d'armoire de commande (100) selon l'une des revendications précédentes, le conduit de circulation (215) comprenant un premier sous-conduit (219), un deuxième sous-conduit (221), un troisième sous-conduit (223) et un quatrième sous-conduit (225), le premier sous-conduit (219) et le deuxième sous-conduit (221) étant disposés parallèlement l'un à l'autre, le troisième sous-conduit (223) et le quatrième sous-conduit (225) étant disposés parallèlement l'un à l'autre, chaque élément de raccordement de base (203) comportant une première ouverture de circulation (227) et une deuxième ouverture de circulation (229), la première ouverture de circulation (227) étant en communication fluidique avec le premier sous-conduit (225) et la deuxième ouverture de circulation (229) étant en communication fluidique avec le deuxième sous-conduit (225), l'élément de raccordement fonctionnel (303) comportant une première ouverture d'accouplement (321) et une deuxième ouverture d'accouplement (323), la première ouverture d'accouplement (321) et la deuxième ouverture d'accouplement (323) étant chacune en communication fluidique avec un intérieur du boîtier fonctionnel (301), la première ouverture d'accouplement (321) pouvant être accouplée à la première ouverture de circulation (229) et la deuxième ouverture d'accouplement (323) pouvant être accouplée à la deuxième ouverture de circulation (229) et une différence de pression pouvant être obtenue par le flux d'air en circulation entre le premier sous-conduit (219) et le deuxième sous-conduit (221), lequel flux d'air est généré par une différence de température à l'intérieur du boîtier fonctionnel (301) ou à l'intérieur du conduit de circulation (215) ou par l'élément formant ventilateur (218).

11. Système d'armoire de commande (100) selon la revendication 10, la première ouverture d'accouplement (321) et la deuxième ouverture d'accouplement (323) étant disposées à deux extrémités opposées les plus extérieures de l'élément de raccordement fonctionnel (303), et les bornes de données (307) et les bornes de tension (305) étant disposées sur l'élément de raccordement fonctionnel (303) entre la première ouverture d'accouplement (321) et la deuxième ouverture d'accouplement (323).

12. Système d'armoire de commande (100) selon l'une des revendications précédentes, un élément formant ventilateur intérieur étant disposé à l'intérieur du boîtier fonctionnel (301), l'élément formant ventilateur intérieur étant conçu pour guider l'air de refroidissement le long d'au moins une paroi intérieure du boîtier fonctionnel (301), et/ou un autre élément formant ventilateur intérieur étant disposé à l'intérieur du boîtier de base (201), l'autre élément formant ventilateur intérieur étant conçu pour guider l'air de refroidissement le long d'au moins une paroi intérieure du boîtier de base (201).

13. Système d'armoire de commande (100) selon l'une des revendications précédentes, les composants (329) du circuit fonctionnel électronique (313) du module fonctionnel (300) présentant un contact thermique avec une paroi intérieure du boîtier fonctionnel (301), et/ou le boîtier fonctionnel (301) et/ou le boîtier de base (201) étant réalisés à partir d'une matière ayant une conductivité thermique d'au moins 10 W/mK , et/ou le boîtier fonctionnel (301) et/ou le boîtier de base (201) étant recouverts d'un revêtement ayant une conductivité thermique d'au moins 10 W/mK.

14. Module fonctionnel (300) destiné à un système d'armoire de commande (100) selon l'une des revendications précédentes 1 à 13, le module fonctionnel (300) comportant un boîtier fonctionnel (301) pourvu d'un côté de boîtier inférieur (302), un élément de raccordement fonctionnel (303) pourvu de bornes de tension (305) et de bornes de données (307) étant disposé sur le côté de boîtier inférieur (302), au moins un circuit fonctionnel électronique (313), qui est relié aux bornes de tension (305) et aux bornes de données (307) de l'élément de raccordement fonctionnel (303), étant disposé dans le boîtier fonctionnel (301), le module fonctionnel (300) pouvant être relié au module de base (200) par un accouplement de l'élément de raccordement fonctionnel (303) à un élément de raccordement de base (203) d'un module de base (200) du système d'armoire de commande (100) et une liaison des bornes de tension (305) et des bornes de données (307) de l'élément de raccordement fonctionnel (303) pouvant être établie avec les bornes de tension de base (205) et les bornes de données de base (207) de l'élément de base (200), l'élément de raccordement fonctionnel (303) comportant des ouvertures d'accouplement (309), les ouvertures d'accouplement (309) étant en communication fluidique avec un intérieur du boîtier fonctionnel (301), les ouvertures d'accouplement (309) pouvant être accouplées aux ouvertures de circulation (217) d'un module de base (200) du système d'armoire de commande, et une liaison fluidique pouvant être établie entre un conduit de circulation (215) du module de base (200) et l'intérieur du boîtier fonctionnel (301) par accouplement des ouvertures d'accouplement (309) avec les ouvertures de circulation (217) et un circuit de circulation (101) qui est fluidiquement fermé et qui comprend le conduit de circulation (215) et l'intérieur du boîtier fonctionnel (301) pouvant être formé dans lequel un flux d'air peut circuler en ce que le flux d'air quitte le conduit de circulation (215) par une ouverture d'accouplement (309) pour entrer à l'intérieur du boîtier fonctionnel (301) et s'écoule de l'intérieur du boîtier fonctionnel (301) de nouveau dans le conduit de circulation (215) par une autre ouverture d'accouplement (309).
